# EUROPEAN PATENT APPLICATION

(11) **EP 2 830 393 A1**
(43) Date of publication of application: **28.01.2015**
(21) Application number: 13812642.0
(22) Date of filing: 04.07.2013
(51) Int. Cl.: H05B 33/06, H01L 51/50

(54) **ORGANIC EL MODULE AND ELECTRICTY SUPPLY STRUCTURE FOR ORGANIC EL MODULE**

(30) Priority: 06.07.2012 JP 2012152364; 18.07.2012 JP 2012159447
(71) Applicant: Kaneka Corporation, Osaka-shi, Osaka 530-8288 (JP)
(72) Inventor: MATSUDA, Kuniharu, Tokyo 107-6025 (JP)
(74) Representative: Hoffmann Eitle
(86) International application number: PCT/JP2013/068353
(87) International publication number: WO 2014/007322

(57) **Abstract**

The present invention aims at providing a further downsizable organic EL module. A first and a second power supply member void parts are formed on a first and a second power supply members, respectively. The first and the second power supply members are different in shape, so that at least a part of the first power supply member is located in a vertically projected region of the second power supply member void part and at least a part of the second power supply member is located in a vertically projected region of the first power supply member void part when the first and the second power supply members overlap each other with an insulation layer sandwiched between. One of electric wires penetrates the second power supply member to be connected to the first power supply member. The first power supply member is connected to one of a first and a second electrode layers directly or via a conducting member. The second power supply member, to which the other of the electric wires is connected, is connected to the other of the layers directly or via a conducting member.

## Description

### TECHNICAL FIELD

The present invention relates to an organic EL (Electro Luminescence) module mainly used for lighting. The present invention also relates to a power supply structure made up of organic EL modules using such an organic EL module.

### BACKGROUND ART

Recently, organic EL modules are attracting attention as lighting equipment taking the place of an incandescent light or a fluorescent light and have been studied well.

An organic EL module is made up of organic EL devices with sealing structures or casings provided. Organic EL devices each are formed by laminating a substrate such as a glass substrate, a transparent resin film, or a metal sheet with an organic EL element, thereby making up a power supply structure for supplying power to the organic EL element.

An organic EL element is formed by stacking a light emission layer, which is composed of organic compounds, between two electrodes, either one or both of which have transparency and are made to face each other. An organic EL device emits light by energy generated in recombination of electrically excited electrons and holes.

In short, an organic EL module is a self-emitting device that can emit light of various wavelengths by appropriately selecting a material of the light emission layer.

Further, an organic EL module advantageously has few restrictions of a place of installation, since it is extremely smaller in thickness and lighter than an incandescent light, a fluorescent light, and a LED light and emits light planarly. Further, an organic EL module also advantageously has small power consumption and generates little heat since it has a higher luminous efficiency than an incandescent light and a fluorescent light.

Patent document 1 specified below discloses one organic EL device, for example. The organic EL device (organic dispersion type EL panel) disclosed in Patent document 1 has a power supply part for supplying power to a transparent electrode layer, the part being composed of a two layer structure of a metal foil and a metal paste. This minimizes electric resistance by the metal foil and keeps good contact between the transparent electrode and the metal foil portion with the metal paste.

Patent document 2 specified below discloses one organic EL module, for example. The organic EL module disclosed in Patent document 2 is provided with electrodes disposed outside of an outer periphery of a light emitting part (sealing part) of an organic EL element. The light emitting part has a substantially square shape in a planar view with four sides. A part of the electrodes is arranged outside of the respective sides. Specifically, a part of an anode having a substantially rectangular shape in a planar view and a part of a cathode having a substantially rectangular shape in a planar view are alternately arranged in a circumferential direction of the outer periphery of the light emitting part. More specifically, when a part of the anode is arranged outside of one side selected from the four sides constituting the outer periphery of the light emitting part, a part of the cathode is arranged outside of respective two sides continuous to the one side. When a part of the cathode is arranged outside of one side selected from the four sides constituting the outer periphery of the light emitting part, a part of the anode is arranged outside of respective two sides continuous to the one side.

Further, the organic EL module disclosed in Patent document 2 has two wiring boards each having a substantially "U" shape in a planar view. The two wiring boards are arranged in different orientations so that open portions in the respective "U" shapes face in different directions. Specifically, one wiring board is arranged in an orientation in which the other wiring board is rotated by 90 degrees. Furthermore, the two wiring boards are different in size and are arranged so that one wiring board surrounds the other wiring board. In this way, the two wiring boards are arranged so as not to contact with each other and so that one wiring board contacts with a part of the two anodes located outside of the outer periphery of the light emitting part and the other wiring board contacts with a part of the two cathodes located outside of the outer periphery of the light emitting part.

Herein, the organic EL module disclosed in Patent document 2 forms the wiring boards each having the substantially "U" shape in a planar view by a bending process, thereby reducing a working loss compared with a cutout process from a plate-like conductor.

### PATENT DOCUMENT

Patent Document 1: JP H06-223969 A
Patent Document 2: JP 2010-192822 A

### DISCLOSURE OF INVENTION

### TECHNICAL PROBLEM

However, the organic EL device in the art has room for improvement necessary for further downsizing. In the organic EL module disclosed in Patent document 2, for example, one of the wiring boards is located outside of the outer periphery of the light emitting part and the other of the wiring boards is located further outside thereof, as described above. Thus, the two wiring boards are aligned in parallel outside of the outer periphery of the light emitting part, rendering a length from the outer periphery of the light emitting part to the outer periphery of the whole organic EL module longer. In short, in the structure of the organic EL module disclosed in Patent document 2, it is difficult to downsize the module because the module increases in size (such as width or depth) in a horizontal direction of the module.

In view of the above-mentioned problems and drawbacks, the present invention therefore aims to provide an organic EL module that can be further downsized. Further, the present invention aims to provide a power supply structure made up of organic EL modules for supplying power to such organic EL modules.

### SOLUTION TO PROBLEM

An aspect of the present invention to solve the above-mentioned problems and drawbacks is an organic EL module incorporating an organic EL device having a layer structure formed of at least a first electrode layer, an organic light-emitting layer, and a second electrode layer and stacked on a substrate having a planar expanse, wherein the substrate has sides or a peripheral part, including a first power supply member, an insulation layer, a second power supply member, and at least two electric wires, the first power supply member and the second power supply member each having a plate or foil shape and having an outer edge part and an edge end, the first power supply member and the second power supply member having a first power supply member void part and a second power supply member void part formed by cutting out a part of the members, respectively, the first power supply member and the second power supply member being different in shape from each other, at least a part of the first power supply member being located in a region where the second power supply member void part is vertically projected and at least a part of the second power supply member being located in a region where the first power supply member void part is vertically projected when the first power supply member and the second power supply member overlap, the first power supply member and the second power supply member overlapping each other with the insulation layer sandwiched therebetween, one of the electric wires penetrating the second power supply member being connected to the first power supply member, the first power supply member, to which the one of the electric wires is connected, being connected to one selected from a group consisting of the first electrode layer and the second electrode layer either directly or via a conducting member, and the second power supply member, to which the other of the electric wires is connected, being connected to the other selected from the group consisting of the first electrode layer and the second electrode layer either directly or via a conducting member.

In the organic EL module in this aspect, the first power supply member and the second power supply member for supplying electricity to the first electrode layer and the second electrode layer of the organic EL device each are a plate or foil shape and are relatively thin. Thus, with the first and the second power supply members overlapped, the organic EL module is sufficiently thin without increasing the total thickness of the organic EL module.

Further, in the organic EL module in this aspect, the first power supply member and the second power supply member have the first power supply member void part and the second power supply member void part formed by cutting out a part of the members, respectively, so as to be different in shape from each other. At least a part of the first power supply member is located in a region where the second power supply member void part is vertically projected and at least a part of the second power supply member is located in a region where the first power supply member void part is vertically projected when the first and the second power supply members overlap each other with the insulation layer sandwiched therebetween.

Thus, in the organic EL module in this aspect, a part of one of the members is prevented from overlapping with the other of the members when the first and the second power supply members overlap each other with the insulation layer sandwiched therebetween, so that the first and the second power supply members are connected to (in contact with) the first and the second electrode layers of the organic EL device without increasing a size in a horizontal direction (such as width and depth).

Specifically, when the first and the second power supply members are respectively connected to (brought into contact with) the first and the second electrode layers, it is necessary to prevent electrical contact between the first power supply member and the second power supply member so as to prevent a failure such as a short circuit. However, a structure to prevent such contact by arranging the first and the second power supply members at positions shifted in a horizontal direction, in such a manner as arranging the second power supply member inside or outside of the first power supply member, for example, may increase the organic EL module in size in the horizontal direction. In contrast, the organic EL module in this aspect, since a part of one of the first and the second power supply members does not overlap the other of the members when the members overlap each other with the insulation layer sandwiched therebetween, electrical contact of the members is prevented without the first and the second power supply members arranged at positions largely shifted in the horizontal direction. Consequently, the organic EL module in this aspect is made in a required minimum size (such as width and depth) in the horizontal direction of the module because the first power supply member and the second power supply member are not largely shifted in position in the horizontal direction when overlapped with each other.

As described above, the organic EL module in this aspect can be sufficiently small in thickness and made in a required minimum size (such as width and depth) in the horizontal direction of the module, so as to be further downsized.

Preferably, the first power supply member void part is formed at the outer edge part of the first power supply member, and at least a part of the second power supply member is located outward of the edge end of the first power supply member.

Further, the second power supply member void part is preferably formed at the outer edge part of the second power supply member, and at least a part of the first power supply member is located outward of the edge end of the second power supply member.

According to these preferred aspects, the first and the second power supply member void parts are formed by a relatively simple process such as cutting out part of the outer edge part. A complicated process is not required in order to expose a part of the second power supply member or a part of the first power supply member at the first power supply member void part or the second power supply member void part.

Preferably, the organic EL module has a first conductive region formed adjacent to the side of the substrate, wherein the first conductive region is conducted with one selected from a group consisting of the first power supply member and the second power supply member, and has a second conductive region formed adjacent to the side of the substrate and at a position different from the first conductive region, wherein the second conductive region is conducted with the other selected from the group consisting of the first power supply member and the second power supply member, a part located at the outer edge part of the second power supply member and outward of the edge end of the first power supply member being in contact with one selected from a group consisting of the first conductive region and the second conductive region, and a part located at the outer edge part of the first power supply member and outward of the edge end of the second power supply member being in contact with the other selected from the group consisting of the first conductive region and the second conductive region.

This preferred aspect constructs the above-mentioned organic EL module relatively easily.

Preferably, the first power supply member and the second power supply member are formed by punching a metal foil or a metal plate. Alternatively, it is possible to form the members by punching a metal plate and further bending the plate.

Further, the first power supply member and the second power supply member each preferably have a main body and a leg part, the main body having a flat plate shape and an outer edge constituted by sides, and the leg part being formed integrally with the side of the main body.

Further, the leg part preferably has a projecting piece part projecting from the outer edge of the main body to a direction containing components of a horizontal direction and a vertical wall part projecting downwardly from the projecting piece part, the leg part of the first power supply member being separated from the second power supply member and the leg part of the second power supply member being separated from the first power supply member.

Further, the second power supply member preferably has a throughhole for inserting one of the electric wires therethrough.

According to this preferred aspect, when power supply lines (power supply members) are connected to the first power supply member and the second power supply member, respectively, from above, with the members overlapping, it is not necessary to extend the power supply line to be connected to the first power supply member so as to bypass the second power supply member and is only necessary to make the power supply line penetrate the throughhole of the second power supply member. Therefore, a connection structure of the power supply lines can be simplified.

Preferably, the organic EL module further includes a module member covering either at least one side of the substrate or at least a part of a surface of the substrate, the module member being a frame or a planar body, and the module member pressing and fixing the first power supply member and the second power supply member.

More preferably, the module member has a module throughhole penetrating a part of the member in a member thickness direction, the module throughhole being at least a part of a communicating hole extending from outside to the first power supply member and/or at least a part of a communicating hole extending from outside to the second power supply member.

In this preferred aspect, since the module throughhole is "at least a part of a communicating hole extending from outside to the first power supply member," at least a part of the first power supply member is exposed outside via the module throughhole (or the communication hole including the module throughhole) in a case where no member is arranged within the module throughhole (or the communication hole including the module throughhole). Similarly, at least a part of the second power supply member is exposed outside via the module throughhole (or the communication hole including the module throughhole) in a case where no member is arranged within the module throughhole (or the communication hole including the module throughhole).

More specifically, the organic EL module has a connector insertion hole for inserting one of the electric wires therethrough, wherein the connector insertion hole extends through the second power supply member, and has adjacent to the connector insertion hole a position adjustment hole for adjusting a position of the electric wires, wherein the position adjustment hole extends through at least the second power supply member.

Further, the organic EL module preferably has the module member formed by a ferromagnetic planar body of a plate or foil shape.

According to this preferred aspect, the organic EL module in this aspect is easily attached to a ceiling, a wall surface, or the like via a magnet or the like.

Specifically, when attached to a ceiling, a wall surface, or the like, the organic EL module is generally attached to a member such as a frame that has been previously fixed to the ceiling, the wall surface, or the like. The organic EL module in this aspect has a ferromagnetic planar body, so as to be easily attached by using a permanent magnet or the like. In short, easy attachment is achieved without it being screwed shut by using a frame to which a permanent magnet is integrally attached or interposing a permanent magnet between the frame and the organic EL module.

Herein, when the organic EL module is used as lighting equipment, a plurality of organic EL modules are sometimes placed without gaps on a ceiling, a wall surface, or the like. In this case, generally, a predetermined organic EL module is electrically connected to an external power source, while other organic EL modules are electrically connected to the predetermined organic EL module via a lead wire or the like. Specifically, a plurality of parallelly-arranged organic EL modules are used when mutually electrically connected, which supplies electricity to the organic EL modules.

However, mutual connection of the organic EL modules in the conventional art via a lead wire or the like may decrease a voltage toward the downstream side of the lead wire, which is a so-called voltage drop. Herein, an organic EL element serving as a luminous body of an organic EL module emits light of a luminance (emission intensity) according to an applied voltage value. Thus, a voltage drop due to extension of the lead wire or the like may cause luminance nonuniformity (emission nonuniformity) of the organic EL modules.

Therefore, it is preferable that the first power supply member is conducted with one selected from a group consisting of the first electrode layer and the second electrode layer, that the second power supply member is conducted with the other selected from the group consisting of the first electrode layer and the second electrode layer, that the first power supply member and the second power supply member forming connecting parts in pairs, and that the connecting parts being formed at either a plurality of sides of the substrate or a plurality of parts of the peripheral part of the substrate, so that a conductive body other than the components of the organic EL module has direct contact with the respective connecting parts from a side face of the organic EL module.

According to this preferred aspect, the parallelly-arranged organic EL modules are electrically connected without extending a conductive body such as a lead wire longer.

Preferably, the substrate is polygonal or circular in shape, and at least a part of the connecting parts is arranged on at least two opposing sides of the substrate.

Further, the connecting parts preferably project outwardly from the sides or the peripheral part of the substrate.

Another aspect of the present invention is an organic EL module incorporating an organic EL device having a layer structure formed of at least a first electrode layer, an organic light-emitting layer, and a second electrode layer and stacked on a substrate having a planar expanse, wherein the substrate has sides or a peripheral part, including connecting parts each constituted by a pair of conducting members, wherein the conducting members mainly consist of a first conducting member conducted to the first electrode layer and a second conducting member conducted to the second electrode layer, the connecting parts being formed at either a plurality of sides or a plurality of parts of the peripheral part of the substrate, so that a conductive body other than components of the organic EL module has direct contact with the respective connecting part from a side face side of the organic EL module.

Preferably, the substrate is polygonal or circular in shape, and at least a part of the connecting parts is arranged on at least two opposing sides of the substrate.

Further, the connecting parts preferably project outwardly from the sides or the peripheral part of the substrate.

More preferably, the organic EL module includes a first power supply member, an insulation layer, and a second power supply member, the first power supply member and the second power supply member having a plate or foil shape, the first power supply member and the second power supply member having a first power supply member void part and a second power supply member void part formed by cutting out a part of the members, respectively, the first power supply member and the second power supply member being different in shape from each other, at least a part of the first power supply member being located in a region where the second power supply member void part is vertically projected and at least a part of the second power supply member being located in a region where the first power supply member void part is vertically projected when the first power supply member and the second power supply member overlap, the first power supply member and the second power supply member overlapping each other with the insulation layer sandwiched therebetween, the first power supply member being connected to one selected from a group consisting of the first electrode layer and the second electrode layer either directly or via a conducting member, the second power supply member being connected to the other selected from the group consisting of the first electrode layer and the second electrode layer either directly or via a conducting member, and the first power supply member and the second power supply member respectively serving as the first conducting member and the second conducting member, so as to constitute the connecting part in pairs.

Further, it is preferable that the above-mentioned preferred aspects each are easily attachable to another member with a magnetic power.

Still another aspect of the present invention is a power supply structure made up of organic EL modules, wherein the organic EL modules described above are placed without gaps with a planar expanse, the connecting parts belonging to adjacent organic EL modules that are connected to each other, and at least one of the organic EL modules being electrically connected to an external electrode.

The connecting parts are preferably connected to each other above the substrate.

Further, the connecting parts are preferably connected to each other outside of the substrate.

More preferably, a power supply structure made up of the organic EL modules described above is made by connecting a plurality of parallelly-connected module rows in series, each of the parallelly-connected module rows being made up of the organic EL modules adjacently located and electrically connected to each other in parallel.

### ADVANTAGEOUS EFFECT OF INVENTION

According to the present invention, the organic EL module is made sufficiently small in thickness and made in a required minimum size (such as width and depth) in a horizontal direction of the module. That provides the organic EL module with the effect of being further downsizable.

### BRIEF DESCRIPTION OF DRAWINGS

Fig. 1 is a schematic diagram showing an installation state of an organic EL module relating to a first embodiment of the present invention;
Fig. 2 is an exploded perspective view of the organic EL module in Fig. 1;
Fig. 3 is an exploded perspective view of an electricity supply part in Fig. 2;
Fig. 4 is a cross section taken along a line A-A showing the electricity supply part in Fig. 2 with a main part enlarged;
Fig. 5 is a perspective view of the electricity supply part in Fig. 2 seen through a heat conductive sheet;
Fig. 6 is a cross section taken along a line B-B showing the electricity supply part in Fig. 5 with a main part enlarged;
Fig. 7 is a cross section taken along a line C-C showing the electricity supply part in Fig. 5 with the main part enlarged;
Fig. 8 is a perspective view of a part of the electricity supply part in Fig. 2;
Fig. 9 is a perspective view of a part of the electricity supply part seen from a direction different from that in Fig. 8;
Fig. 10 is a plan view of a part of the electricity supply part in Fig. 8;
Fig. 11 is an explanatory diagram showing organic EL modules in a second embodiment of the present invention, the modules being arranged in a matrix;
Fig. 12 is an exploded perspective view of the organic EL module in Fig. 11;
Fig. 13 is an exploded perspective view of an electricity supply part in Fig. 12;
Fig. 14 is a perspective view of a part of the electricity supply part in Fig. 12;
Fig. 15 is a perspective view of a part of the electricity supply part seen from a direction different from that in Fig. 14;
Fig. 16 is a plan view of a part of the electricity supply part in Fig. 14;
Fig. 17 is a perspective view of the organic EL module in Fig. 11;
Figs. 18A and B are explanatory diagrams showing a state of arranging the organic EL modules in

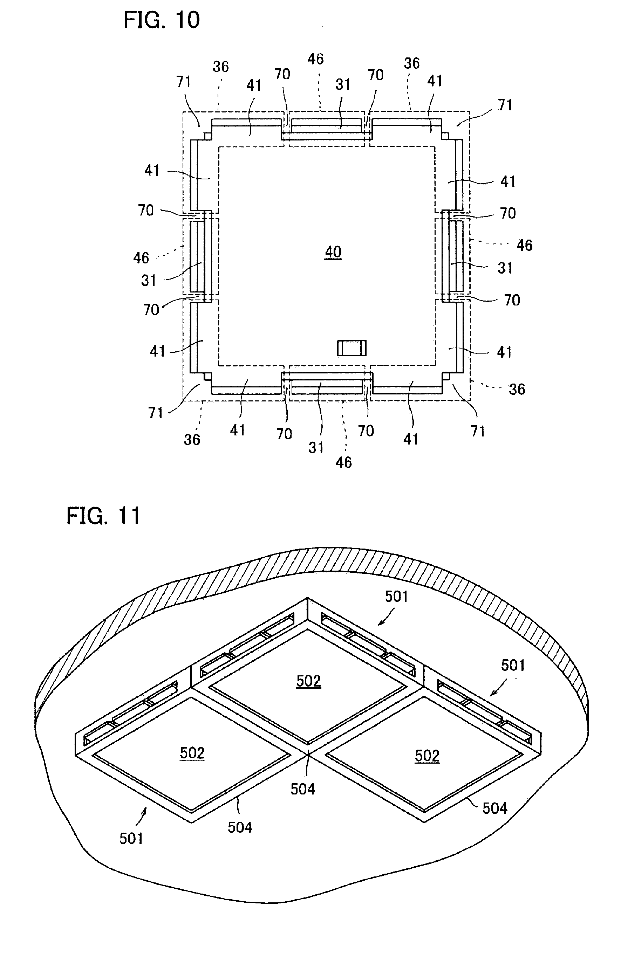

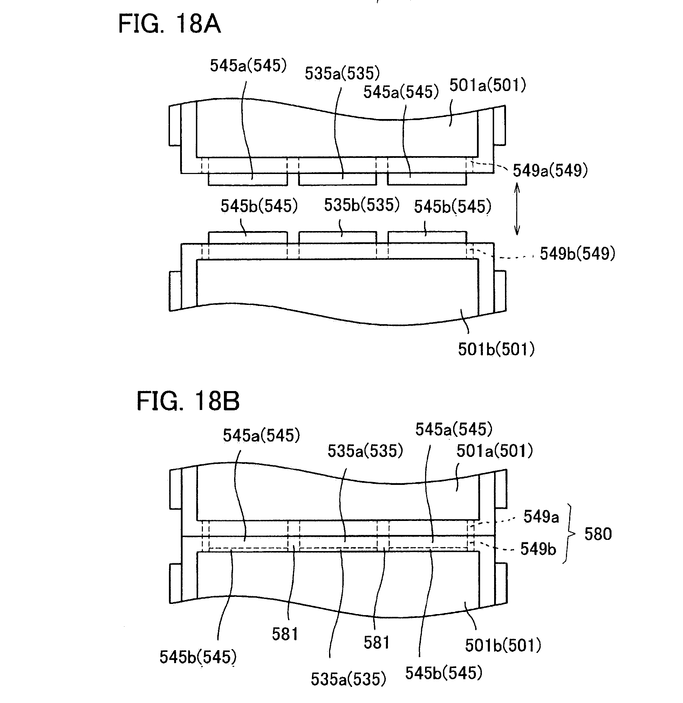

Fig. 11 adjacent to each other and electrically connecting them in parallel in order of Fig. 18A and
Fig. 18B;

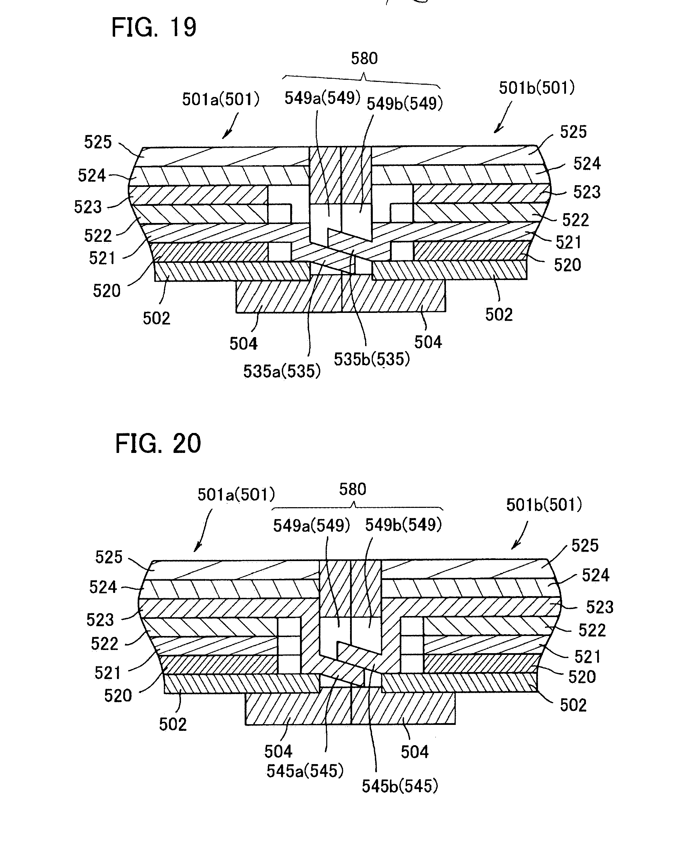

Fig. 19 is a schematic cross section showing a state of arranging the organic EL modules in Fig. 11 adjacent to each other and electrically connecting them in parallel and a state of cathode-side connecting metal fittings of the respective organic EL modules having direct contact with each other;
Fig. 20 is a schematic cross section showing a state of arranging the organic EL modules in Fig. 11 adjacent to each other and electrically connecting them in parallel and a state of anode-side connecting metal fittings of the respective organic EL modules having direct contact with each other;

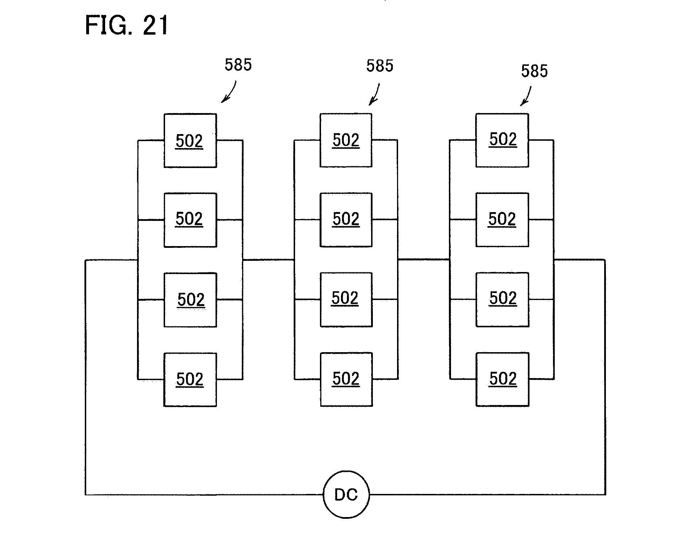

Fig. 21 is an electrical diagram showing an example of a power supply structure when the organic EL modules 501 in Fig. 11 are placed without gaps so as to have a planar expanse;

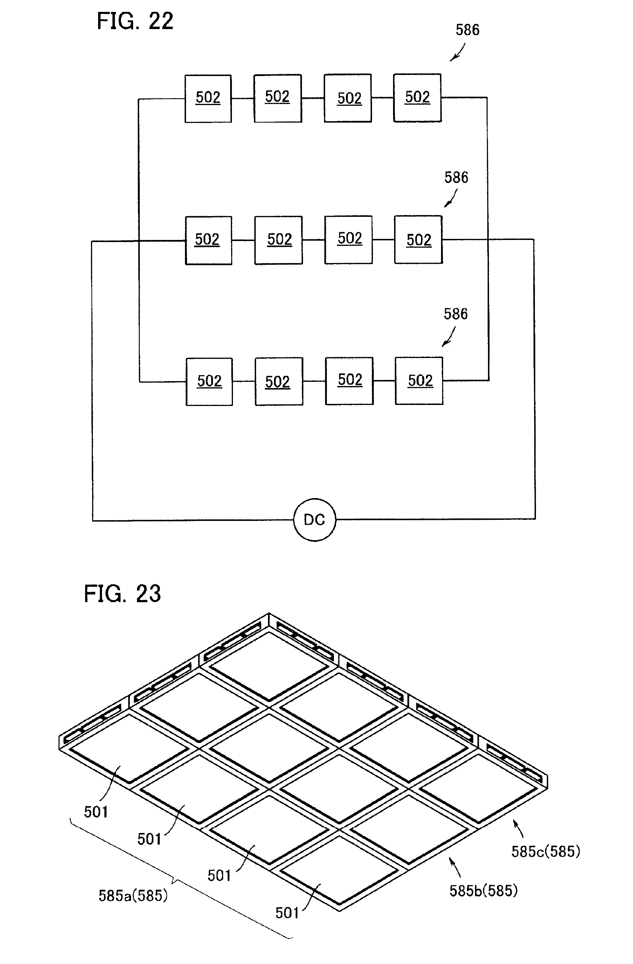

Fig. 22 is an electrical diagram showing another example of the power supply structure, which is an example different from that in Fig. 21, when the organic EL modules 501 in Fig. 11 are placed closely together so as to have a planar expanse;
Fig. 23 is a perspective view showing lighting equipment formed by placing parallelly-connected module rows without gaps, each row being made up of adjacent organic EL modules electrically connected in parallel;

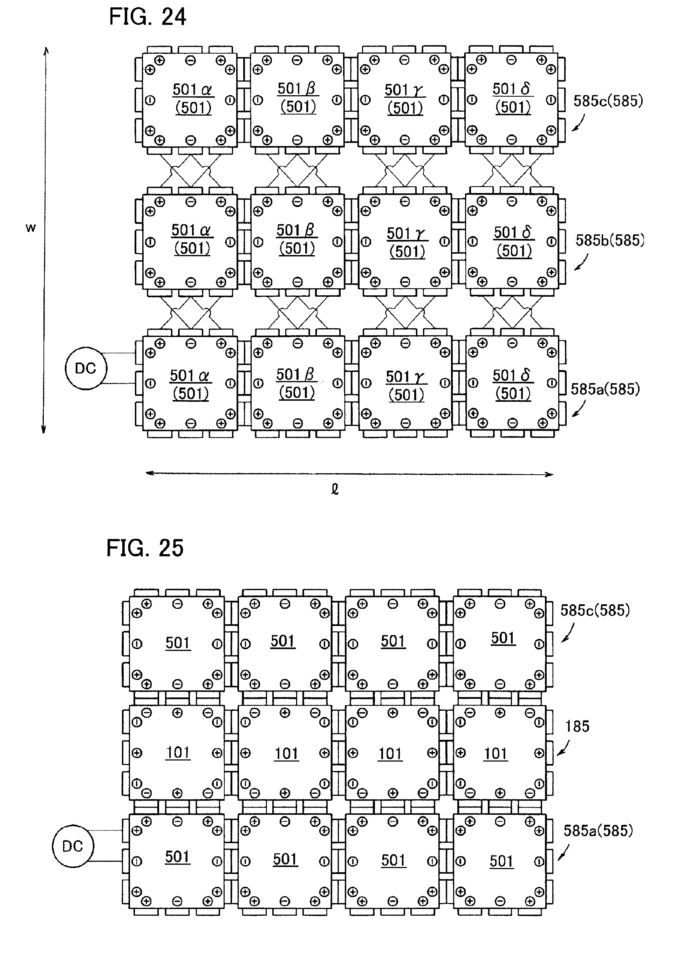

Fig. 24 is a schematic diagram showing a power supply structure in the lighting equipment in Fig. 23;
Fig. 25 is a schematic diagram showing a power supply structure of lighting equipment different from that in Fig. 24;

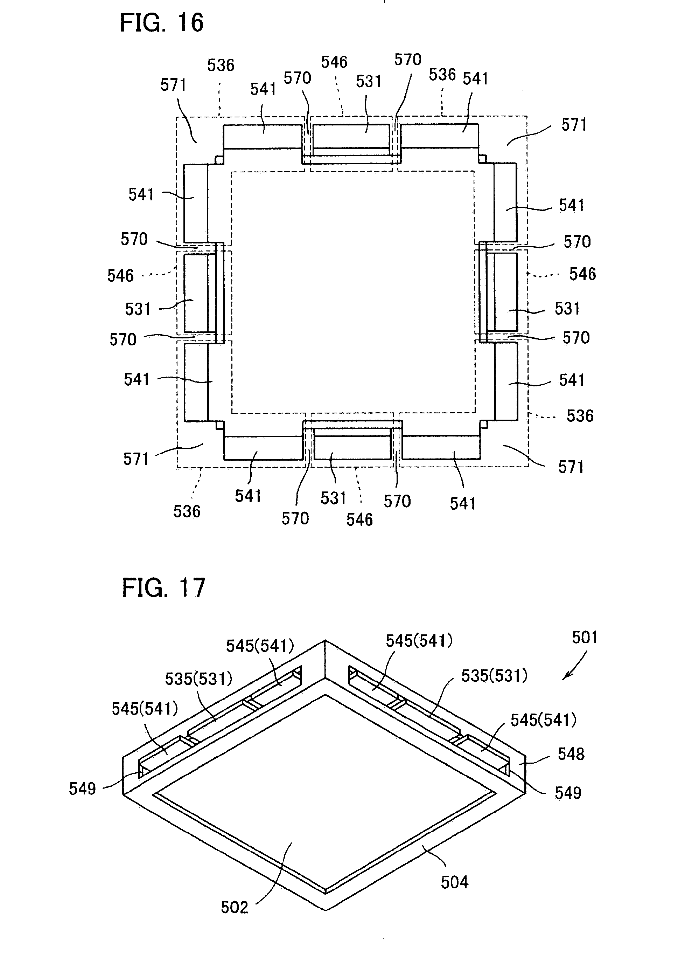

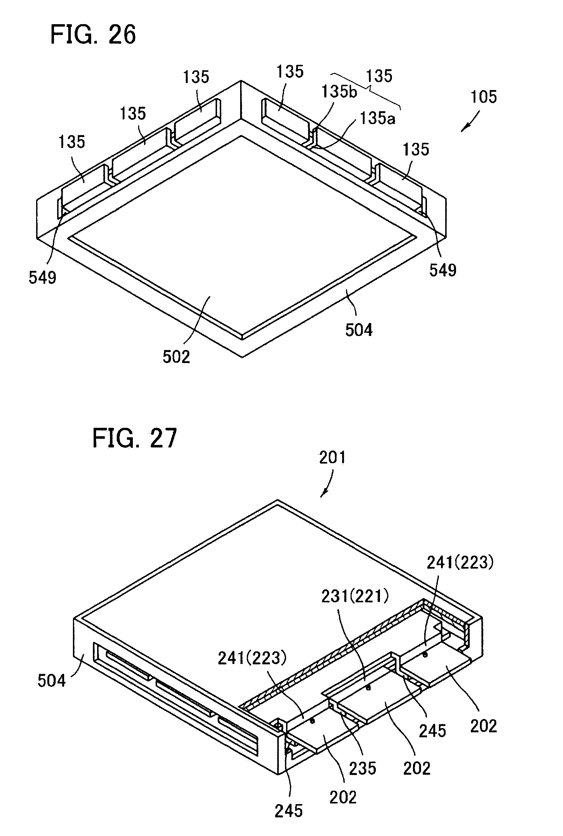

Fig. 26 is a perspective view of an organic EL module different from that in Fig. 17;
Fig. 27 is a partially exploded perspective view of an organic EL module different from those in
Figs. 17 and 26;

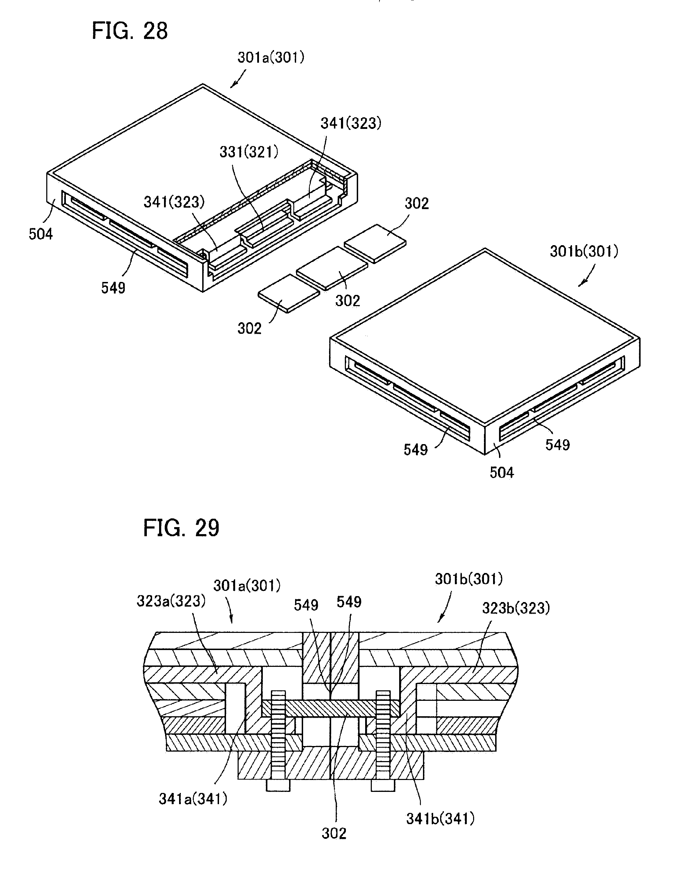

Fig. 28 is an explanatory diagram showing a state of adjacently arranging organic EL modules, which are different from those in Figs. 17, 26, and 27, and connecting them to each other;
Fig. 29 is a cross section showing a state of adjacently arranging the organic EL modules in Fig. 28 and connecting them to each other;

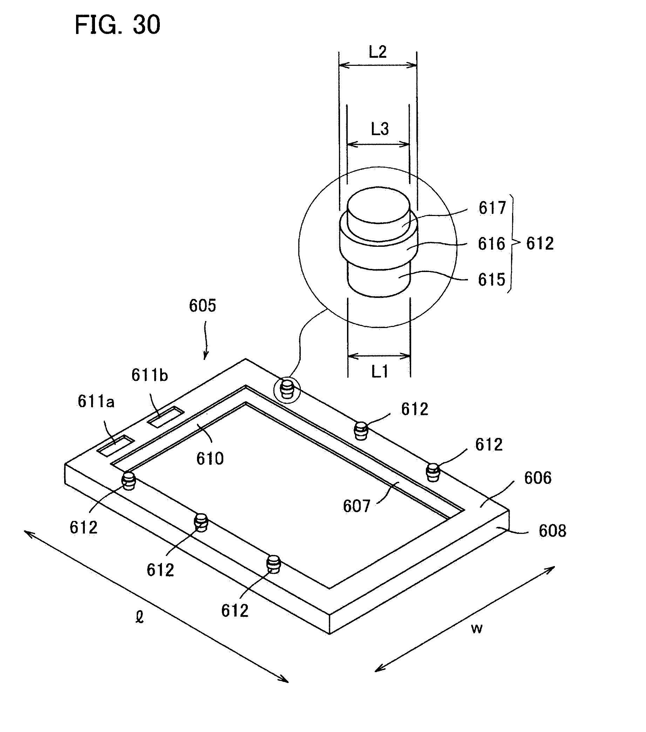

Fig. 30 is a perspective view of a frame different from those in the above-mentioned embodiments;

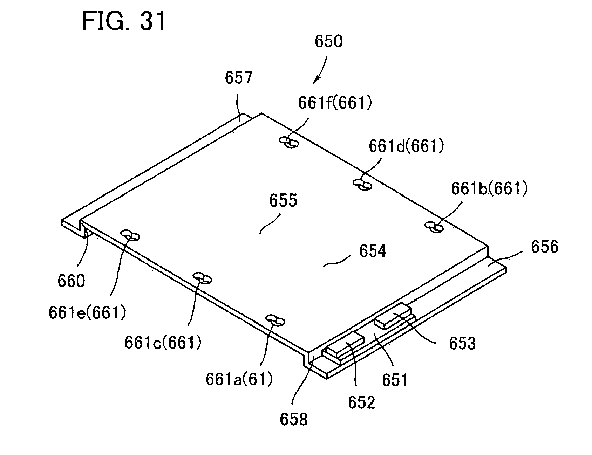

Fig. 31 is a perspective view of a base used in combination with the frame in Fig. 30;

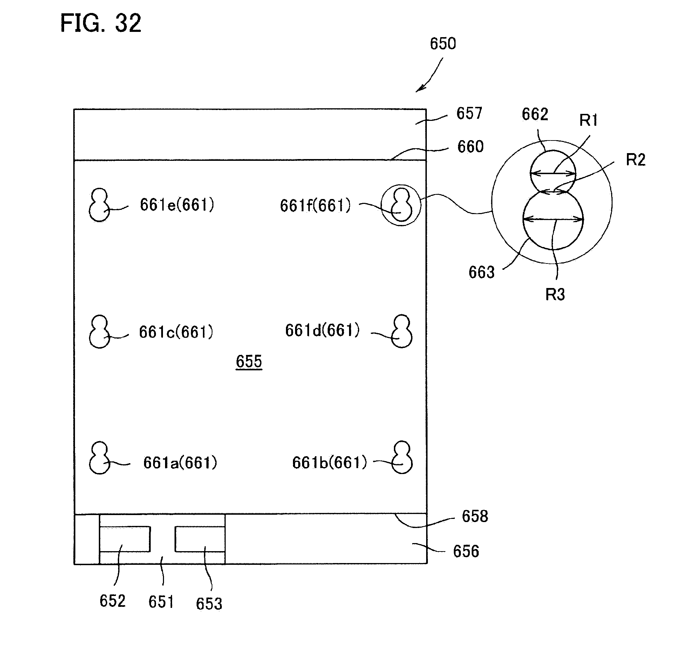

Fig. 32 is a plan view of the base in Fig. 31;

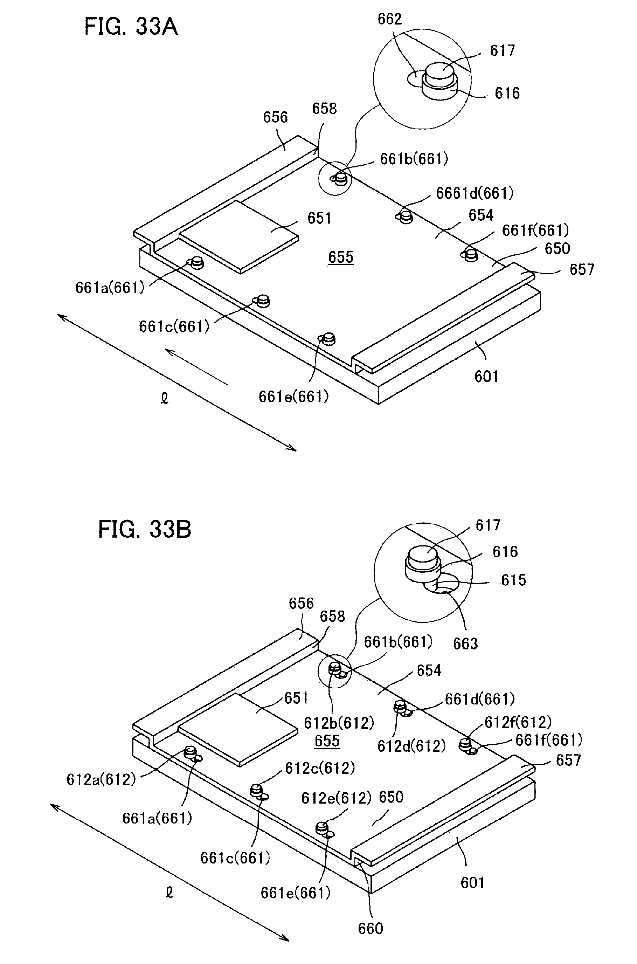

Figs. 33A and B are explanatory diagrams on attaching the organic EL module to the base, in the order of Fig. 33A and Fig. 33B;

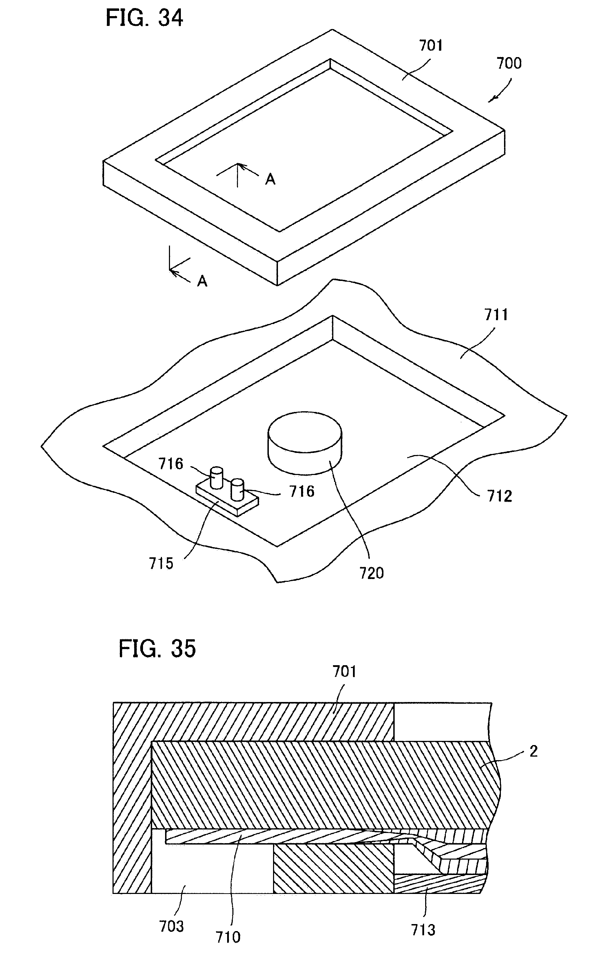

Fig. 34 is a perspective view of an organic EL module and a base different from those in the above-mentioned embodiments;
Fig. 35 is a partially enlarged cross section taken along a line A-A of the organic EL module in Fig. 34; and

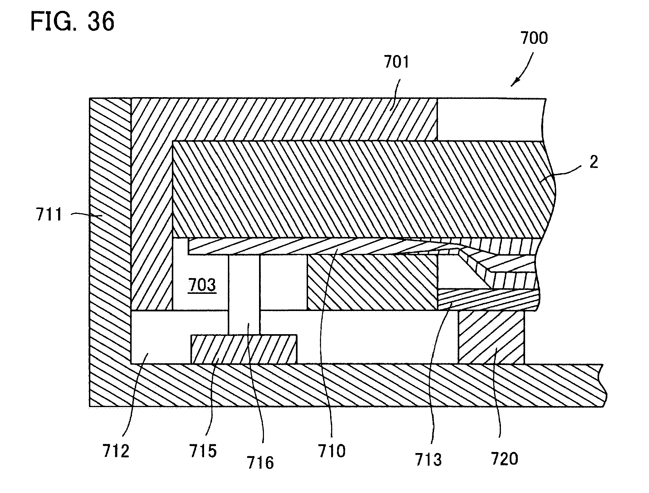

Fig. 36 is a cross section showing a state in which the organic EL module in Fig. 34 is attached to the base.

### DESCRIPTION OF EMBODIMENT

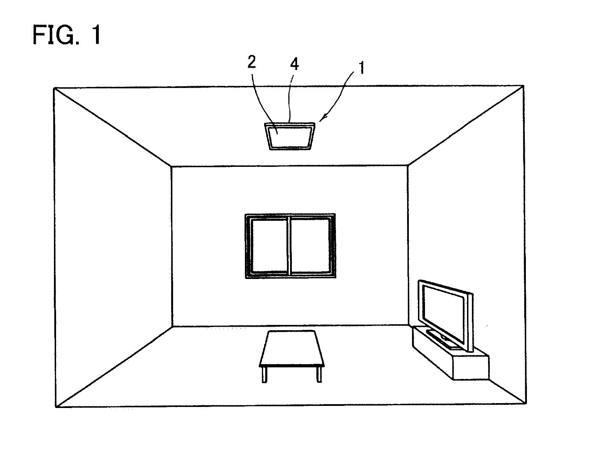

Now, an organic EL module 1 in a first embodiment of the present invention will be described in detail below, making reference to the attached figures. In the description below, directions from front to rear, from up to down, and from right to left are illustrated on the basis of a normal installation state shown in Fig. 1, unless otherwise specifically noted. Specifically, the description is based on an orientation of an organic EL panel 2 (organic EL device) located below.

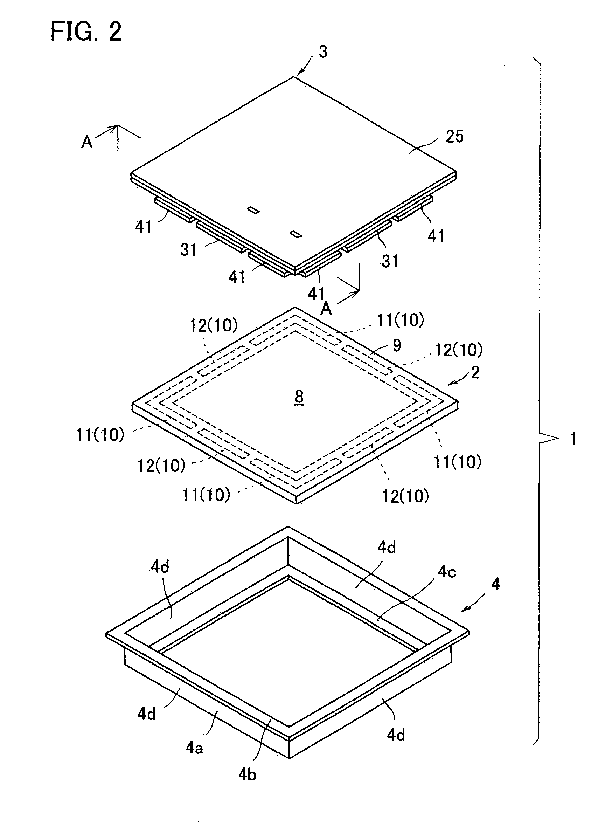

Referring to Fig. 1, the organic EL module 1 in the first embodiment is used as lighting equipment. The organic EL module 1, as shown in Fig. 2, mainly consists of the organic EL panel 2, an electricity supply member 3, and a frame 4.

The organic EL panel 2 has a layered structure formed of a transparent electrode (first electrode layer) serving as an anode, an organic light-emitting layer adapted to emit fluorescence or phosphorescence by containing a fluorescent or phosphorescent material using organic compound, and a metal electrode (second electrode layer) serving as a cathode and stacked on a transparent substrate having a planar expanse and formed of a material such as a flat glass plate or a flat plastic film (not shown as to each layer and layer configuration). The transparent electrode, the organic light-emitting layer, and the metal electrode are sealed by a member such as a glass sealant so that the organic light-emitting layer is not exposed to oxygen.

The organic EL panel 2 is configured so as to emit light from the organic light-emitting layer by supplying power to the transparent electrode and the metal electrode. Herein, the transparent electrode is formed of a material such as ITO (indium tin oxide) and has a light permeability. Hence, the transparent electrode and the substrate located below the organic light-emitting layer each are transparent and have a light permeability, so that light emitted from the organic light-emitting layer is emitted downwardly and outwardly.

The organic EL panel 2 is configured by a light emitting part 8 having a substantially square shape in a planar view and located in a center thereof and a peripheral part 9 surrounding the light emitting part 8 in loop like fashion.

The light emitting part 8 is a light emission region having a substantially square shape in a planar view when power is supplied to the electrodes (the transparent electrode and the metal electrode). The whole bottom face of the light emitting part 8 serves as a light emitting face of the organic EL panel 2.

The peripheral part 9 is a non-emission region when power is supplied to the electrodes (the transparent electrode and the metal electrode). The peripheral part 9 includes electrode parts 10 serving as electric contacts with outside.

The electrode parts 10 consist of first electrode parts 11 (first conductive regions) electrically connected to the transparent electrode and second electrode parts 12 (second conductive regions) electrically connected to the metal electrode, both of which extend in a direction containing components of a thickness direction of the organic EL panel 2 (from inside to outside). Specifically, the first electrode parts 11 and the second electrode parts 12 are mostly located within the organic EL panel 2 and partly exposed to outside of the organic EL panel 2. They extend from inside to outside of the organic EL panel 2 and along a thickness direction of the organic EL panel 2.

The first electrode parts 11 occupy a part of an upper face of the peripheral part 9 and consist of a plurality of regions each having a substantially L shape in a planar view on the upper face of the peripheral part 9.

The second electrode parts 12 also occupy a part of the upper face of the peripheral part 9 and consist of a plurality of regions each having a substantially rectangular shape in a planar view on the upper face of the peripheral part 9.

The substantially L-shaped regions of the first electrode parts 11 and the substantially rectangular-shaped regions of the second electrode parts 12 are annularly and continuously arranged with an interval. More specifically, the first electrode parts 11 consist of four regions each having a substantially L shape in a planar view, which are located at the outer sides of four corners of the light emitting part 8. Each of the substantially rectangular-shaped regions of the second electrode parts 12 is located between the substantially L-shaped regions. In short, the first electrode parts 11 (regions formed by the first electrode parts 11) and the second electrode parts 12 (regions formed by the second electrode parts 12) are alternately located at a predetermined distance in a circumferential direction of the peripheral part 9.

The electricity supply member 3 is located between an external power source not shown and the organic EL panel 2 and forms an electric supply path from the external power source to the organic EL panel 2.

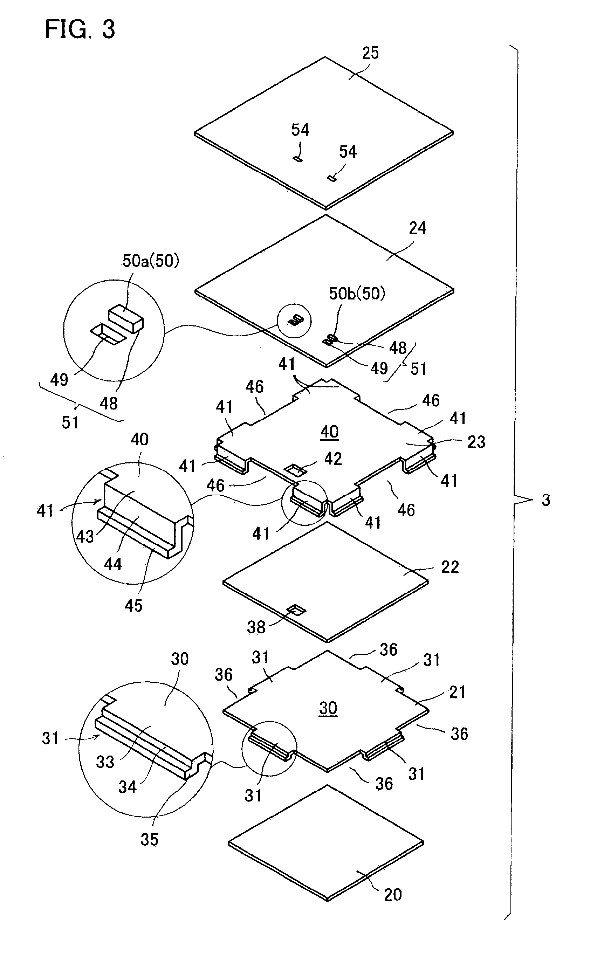

The electricity supply member 3 is, as shown in Fig. 3, formed of a heat equalizing plate 20, a cathode-side connecting metal fitting 21 (first power supply member), an insulation film 22 (insulation layer), an anode-side connecting metal fitting 23 (second power supply member), a top plate forming member 24 (planar body, module member), and a heat conductive sheet 25 stacked in order from the organic EL panel 2 side (bottom side).

Herein, the first power supply member may serve as the anode-side connecting metal fitting 23 and the second power supply member may serve as the cathode-side connecting metal fitting 21.

The heat equalizing plate 20 is a flat-plate member having a substantially square shape in a planar view and is made of a material having a high heat conductivity such as a graphite sheet, aluminum foil, or a carbon sheet. The heat equalizing plate 20 is disposed on a projection surface of a member thickness direction (vertical direction) of the light emitting part 8, so as to indirectly cover the entire surface of the light-emitting face (bottom face of the light emitting part 8). In other words, it covers an entire surface of a face which faces the light-emitting face. Heat generated in the light-emitting face in driving of the organic EL panel 2 is conducted to the heat equalizing plate 20, whereby the heat is equalized planarly and evenly. Consequently, it is possible to prevent heat from being locally concentrated, which achieves no light emission defect due to heat.

The cathode-side connecting metal fitting 21 is made of a metal having a good electric conductivity such as copper and formed by bending a metal foil (or metal plate) previously punched in a predetermined shape. This embodiment employs a tin-plated copper foil as the metal foil. The cathode-side connecting metal fitting 21 includes a main body 30 of a flat plate having a substantially square shape in a planar view and leg parts 31.

The leg parts 31 are formed integrally with sides that form an outer edge of the main body 30. In this embodiment, the leg parts 31 are formed in a plural number, with one leg part 31 formed at each of four sides of the main body 30. Specifically, the leg parts 31 are each located adjacent to a center in a longitudinal direction of each side and formed in a plural number in a circumferential direction of the main body 30 with an interval.

Each of the leg parts 31 is integrally formed of a projecting piece part 33 of a substantially rectangular flat plate projecting outwardly from the outer edge of the main body 30 in a horizontal direction, a vertical wall part 34 hanging downwardly from an outer end of the projecting piece part 33, and a lower plate part 35 of a substantially rectangular flat plate projecting outwardly from a lower end of the vertical wall part 34. In other words, the outer end of the projecting piece part 33 is bent downwardly to form the vertical wall part 34 and the lower end of the vertical wall part 34 is bent outwardly to form the lower plate part 35. Consequently, the lower plate part 35 is located outward away from the main body 30 and downward from a bottom face of the main body 30.

As described above, the leg parts 31 of the cathode-side connecting metal fitting 21 are formed at the four sides of the main body 30 respectively and each located adjacent to the center in the longitudinal direction of each side. Therefore, a part where the leg part 31 is formed in the edge part of the cathode-side connecting metal fitting 21 protrudes outward of its periphery. In the edge part of the cathode-side connecting metal fitting 21, edge ends of parts where the leg parts 31 are not formed are located inward of its periphery (where the leg parts 31 are formed). In other words, it can be also said that a part of the edge parts of the cathode-side connecting metal fitting 21 is missing by partial cutout. The void parts, or the regions adjacent to outside of the edge ends located inward of its periphery, serve as cathode-side void parts 36 (first power supply member void parts).

The cathode-side void parts 36 are, as shown in Fig. 3, located adjacent to the corners of the main body 30 and each have a substantially L shape in a planar view (see Fig. 10). Specifically, each of the cathode-side void parts 36 extends along a circumferential direction of the edge part of the cathode-side connecting metal fitting 21. Each of the parts 36 also extends while partialy bent at a substantially right angle. The cathode-side void parts 36 consist of a plurality of the parts 36 and more specifically, four cathode-side void parts 36 are arranged adjacent to the four corners of the main body 30, respectively. The cathode-side void parts 36 are located in a circumferential direction of the edge part of the cathode-side connecting metal fitting 21 with an interval.

The insulation film 22 is a resin film having excellent smoothness, heat resistance, and electric insulation and can suitably employ a PET (polyethylene-terephthalate) film.

The insulation film 22 has a hole for connecting a connector (connector connecting hole) 38 adjacent to one side selected from the four sides constituting the edge part of the insulation film 22, the hole 38 penetrating the insulation film 22 in its member thickness direction. More specifically, the connector connecting hole 38 is located slightly inward of the edge part of the insulation film 22 and at a position slightly closer to one end than a center in a longitudinal direction of one side belonging to the sides that constitute the edge part and being nearest to the hole 38. Further, the connector connecting hole 38 is a throughhole having a substantially quadrilateral opening. Herein, the connector connecting hole 38 can be located at a center of the light emitting part 8. This is also one of the effects of this embodiment.

The anode-side connecting metal fitting 23 is made of a metal having a good electric conductivity such as copper and formed by bending a metal foil (or a metal plate) previously punched in a predetermined shape. This embodiment employs a tin-plated copper foil as the metal foil. Specifically, the anode-side connecting metal fitting 23 is formed by a material and method similar to the cathode-side connecting metal fitting 21 described above, but has a shape different from the cathode-side connecting metal fitting 21.

The anode-side connecting metal fitting 23 includes a main body 40 of a flat plate having a substantially square shape in a planar view and leg parts 41.

The main body 40 has a hole for connecting a connector (connector connecting hole) 42 adjacent to one side selected from four sides constituting an edge part of the main body 40, the hole 42 penetrating the main body 40 in its member thickness direction. More specifically, the connector connecting hole 42 is located slightly inward of the edge part of the main body 40 and at a position slightly closer to one end than a center in a longitudinal direction of one side belonging to the sides that constitute the edge part and being nearest to the hole 42. Further, the connector connecting hole 42 is a throughhole having a substantially quadrilateral opening.

The leg parts 41 are formed integrally with sides that form an outer edge of the main body 40, respectively. In this embodiment, a plurality of leg parts 41 are formed at the respective four sides of the main body 40. Specifically, two leg parts 41 are located adjacent to both ends in a longitudinal direction of each side, respectively. In other words, each of the leg parts 41 is formed adjacent to the corner of the main body 40. In this embodiment, a gap 71 (see Fig. 10, etc.) is formed between the two leg parts 41 located at each corner. In short, the leg parts 41 are located adjacent to both ends in the longitudinal direction of each side respectively and formed in a plural number in the circumferential direction of the main body 40 with an interval.

Each of the leg parts 41 is integrally formed of a projecting piece part 43 of a substantially rectangular flat plate projecting outwardly from the outer edge of the main body 40 in a horizontal direction, a vertical wall part 44 formed by bending an outer end of the projecting piece part 43 downwardly and hanging downwardly from the outer end of the projecting piece part 43, and a lower plate part 45 of a substantially rectangular flat plate outwardly projecting from a lower end of the vertical wall part 44. Consequently, the lower plate part 45 is located outward away from the main body 40 and downward from a bottom face of the main body 40.

Herein, as described above, two leg parts 41 of the anode-side connecting metal fitting 23 are formed at each of the four sides of the main body 40. The two leg parts 41 are formed adjacent to the both ends in the longitudinal direction of each side, respectively. Therefore, a part where the leg part 41 is formed in the edge part of the anode-side connecting metal fitting 23 protrudes outward of its periphery. In the edge part of the anode-side connecting metal fitting 23, edge ends of parts where the leg parts 41 are not formed are located inward of its periphery (where the leg parts 41 are formed). In other words, it can be also said that a part of the edge part of the anode-side connecting metal fitting 23 is missing by partial cutout. The void parts, or the regions adjacent to outside of the edge ends located inward of its periphery, serve as anode-side void parts 46 (second power supply member void parts).

The anode-side void parts 46 each are, as shown in Fig. 3, located adjacent to a center in the longitudinal direction of each side constituting the edge part of the main body 40 and have a substantially rectangular shape in a planar view (see Fig. 10). The anode-side void parts 46 consist of a plurality of the parts 46 and more specifically, four anode-side void parts 46 are arranged adjacent to positions between the four corners of the main body 40 respectively. The four anode-side void parts 46 are located in a circumferential direction of the edge part of the anode-side connecting metal fitting 23 with an interval.

The top plate forming member 24 is made of a material such as a metal or alloy that is attracted to a magnet. This embodiment employs a substantially square flat-plate member made of iron or a metal containing iron as a major component. In other words, it also can be said that the top plate forming member 24 is made of a magnetic body or a material containing a magnetic body. The top plate forming member 24 also serves as a module member described below.

With such a top plate forming member 24, the organic EL module 1 in this embodiment can be attached to a ceiling, a wall, or the like via a magnetic mounting tool such as a permanent magnet or a mounting tool having a magnetic member.

The top plate forming member 24 serves also as a heat conductive medium in driving of the organic EL panel 2. Specifically, the top plate forming member 24 forms a part of a heat transfer path from the organic EL panel 2 toward outside when heat generated in the organic EL panel 2 is dissipated via a member such as the frame 4 and the heat conductive sheet 25 to the outside.

The top plate forming member 24 has connector connecting holes 48 and holes for mounting work 49, which are holes that penetrate in a member thickness direction of the top plate forming member 24. An elastic connector 50 (electric wire) is inserted in and attached integrally with each of the connector connecting holes 48.

More specifically, the holes for mounting work 49 each are located slightly inward of one side selected from four sides constituting the edge part of the top plate forming member 24 and adjacent to a center in a longitudinal direction of the side and adjacent to one end in the longitudinal direction of the side, respectively. In short, two holes for mounting work 49 are arranged side by side with an interval.

Meanwhile, the connector connecting holes 48 each are located inward of the one side selected from the four sides constituting the edge part of the top plate forming member 24 and further inward of the hole for mounting work 49. Specifically, the holes for mounting work 49 and the connector connecting holes 48 are arranged in parallel with an interval.

Herein, the top plate forming member 24 has the two connector connecting holes 48, which are formed inward of the two holes for mounting work 49, respectively. In short, the two holes for mounting work 49 are formed side by side slightly inward of the one side selected from the four sides constituting the edge part of the top plate forming member 24, while the two connector connecting holes 48 are formed side by side with an interval inward of positions where the two holes for mounting work 49 are formed side by side, respectively In other words, the holes for mounting work 49 and the connector connecting holes 48 constitute two throughhole rows 51, which are located adjacent to the center of the one side selected from the four sides constituting the edge part of the top plate forming member 24 and adjacent to the one end in the longitudinal direction of the one side, respectively.

A suitable elastic connector 50 can be employed having a structure in which a plurality of fine wires (such as conductive fiber or fine metal wire) having electric conductivity are embedded in a material such as rubber having insulating properties and flexibility in its thickness direction or a structure in which conductive rubber (such as conductive silicon rubber) and nonconductive rubber (such as insulating silicon rubber) are stacked. The elastic connector 50 is an anisotropic conductive connector and is designed to deform when adding a low pressure to a macromolecular material and rapidly return to its original shape when the pressure is relieved.

The heat conductive sheet 25 is made of a material having an excellent heat conductivity and flexibility and has a substantially square shape in a planar view (such as Sarcon EGR-11F, Sarcon TR, and Sarcon GSR made by Fuji Polymer Industries Co., Ltd., for example).

The heat conductive sheet 25 is to be positioned between the top plate forming member 24 and a fitting member (plate-like frame, for example) not shown fixed to a ceiling, a wall, or the like when the organic EL module 1 is assembled. The heat conductive sheet 25 is excellent in flexibility as described above, so as to be able to fill a gap generated between the top plate forming member 24 and the fitting member without strongly pressing the organic EL module 1 onto the fitting member. Further, the heat conductive sheet 25 is in close contact with a top face of the top plate forming member 24 in a wide area. This efficiently transfers heat from the top plate forming member 24 to the fitting member.

The heat conductive sheet 25 has holes (connector connecting holes 54) each for connecting a connector, which penetrate the heat conductive sheet 25 in its member thickness direction, formed adjacent to one side selected from four sides constituting the edge part of the heat conductive sheet 25. More specifically, the connector connecting holes 54 are located slightly inward of the one side selected from the four sides constituting the edge part of the heat conductive sheet 25, and adjacent to a center in a longitudinal direction of the side and adjacent to one end in the longitudinal direction of the side, respectively. In short, the two connector connecting holes 54 are arranged side by side with an interval.

The frame 4 is, as shown in Fig. 2, a flexible frame body made of an appropriate material such as silicon resin. More specifically, the frame 4 is constituted by a main body 4a of a substantially square cylinder, an upper flange 4b formed adjacent to an upper end of an outer peripheral surface of the main body 4a, and an inner projecting part 4c formed adjacent to a lower end of an inner peripheral surface of the main body 4a.

The main body 4a is annularly and continuously formed so that vertical wall parts 4d each of a standing rectangular flat plate make up a substantially hollow square shape in a planar view.

The upper flange 4b is a flat plate projecting outwardly from the upper end of the outer peripheral surface of the main body 4a. The upper flange 4b is annularly and continuously formed in a circumferential direction of the main body 4a so as to have a substantially hollow square shape in a planar view. The upper flange 4b has a top face forming a top face of the frame 4.

The inner projecting part 4c is a flat plate projecting inwardly from the lower end of the inner peripheral surface of the main body 4a. The inner projecting part 4c is also annularly and continuously formed in the circumferential direction of the main body 4a so as to have a substantially hollow square shape in a planar view.

Next, an assembly structure of the electricity supply member 3 will be described in detail below.

The electricity supply member 3 is, as described above, made up of the heat equalizing plate 20, the cathode-side connecting metal fitting 21, the insulation film 22, the anode-side connecting metal fitting 23, the top plate forming member 24, and the heat conductive sheet 25 stacked from the organic EL panel 2 side (lower side) (see Fig. 3). At this time, predetermined members making up the layered structure are connected via an adhesive material as needed. The adhesive material can suitably employ RTV rubber or a paste-like material having a high heat conductivity.

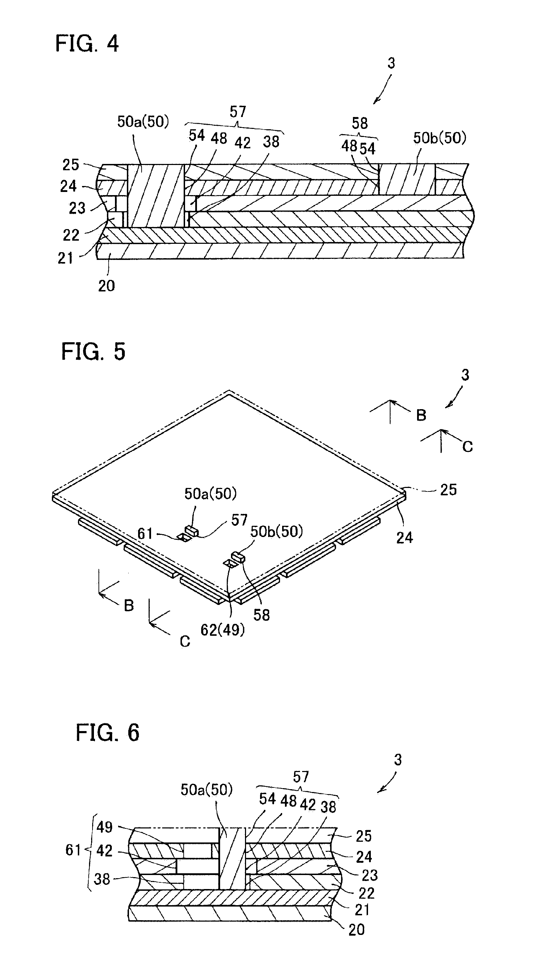

With all the members stacked, as shown in Figs. 3 and 4, one of the connector connecting holes 54 of the heat conductive sheet 25, one of the connector connecting holes 48 of the top plate forming member 24, the connector connecting hole 42 of the anode-side connecting metal fitting 23, and the connector connecting hole 38 of the insulation film 22, among others, communicate so as to form a cathode-side connector insertion hole 57 (see Fig. 4) penetrating the four members. The elastic connector 50a electrically connected to a cathode side of an external power source not shown is inserted in the cathode-side connector insertion hole 57. The lower part of the elastic connector 50a has contact with the cathode-side connecting metal fitting 21. In short, the elastic connector 50a is positioned between the cathode of the external power source not shown and the cathode-side connecting metal fitting 21, thereby electrically connecting these members.

Meanwhile, the other of the connector connecting holes 54 of the heat conductive sheet 25 and the other of the connector connecting holes 48 of the top plate forming member 24 communicate so as to form an anode-side connector insertion hole 58 (see Fig. 4) penetrating the two members. The elastic connector 50b electrically connected to an anode side of the external power source not shown is inserted in the anode-side connector insertion hole 58. The lower side of the elastic connector 50b has contact with the anode-side connecting metal fitting 23. In short, the elastic connector 50b is positioned between the anode of the external power source not shown and the anode-side connecting metal fitting 23, thereby electrically connecting these members.

Herein, as shown in Fig. 5, a cathode-side hole for mounting work 61 is formed at a position closer to the edge end of the electricity supply member 3 than the cathode-side connector insertion hole 57. In addition, an anode-side hole for mounting work 62 is formed at a position closer to the edge end of the electricity supply member 3 than the anode-side connector insertion hole 58.

The cathode-side hole for mounting work 61 is, as shown in Fig. 6, formed of one of the holes for mounting work 49 of the top plate forming member 24, the connector connecting hole 42 of the anode-side connecting metal fitting 23, and the connector connecting hole 38 of the insulation film 22, among others, which communicate so as to penetrate the three members. Thus, the connector connecting hole 42 of the anode-side connecting metal fitting 23 and the connector connecting hole 38 of the insulation film 22 form both a part of the cathode-side hole for mounting work 61 and a part of the cathode-side connector insertion hole 57 described above.

Lower ends of the cathode-side hole for mounting work 61 and of the cathode-side connector insertion hole 57 are located at the same position and the lower ends are located at the same height as the bottom face of the insulation film 22. In other words, the cathode-side hole for mounting work 61 and the cathode-side connector insertion hole 57 are throughholes penetrating from the upper side (from the top plate forming member 24 or the heat conductive sheet 25) into the insulation film 22. In this way, the cathode-side hole for mounting work 61 whose lower end is at the same height as the cathode-side connector insertion hole 57, in which the elastic connector 50a is inserted, is formed slightly away from the hole 57, so that the elastic connector 50a is firmly fixed.

Specifically, in assembly of the electricity supply member 3, it is necessary to insert the elastic connector 50a into the cathode-side connector insertion hole 57 of the top plate forming member 24, to adjust a vertical position of the elastic connector 50a relative to the top plate forming member 24, and to fix the elastic connector 50a at the adjusted position. Thus, in this embodiment, the cathode-side hole for mounting work 61 is formed adjacent to the cathode-side connector insertion hole 57. This deforms the top plate forming member 24 so as to decrease the diameter of the cathode-side connector insertion hole 57 by striking an inner peripheral surface of the cathode-side hole for mounting work 61 with an instrument such as a driver after the position adjustment of the elastic connector 50a having been inserted into the cathode-side connector insertion hole 57. Specifically, application of impact on the inner peripheral surface of the cathode-side hole for mounting work 61 from the cathode-side hole for mounting work 61 side to a direction toward the cathode-side connector insertion hole 57 side increases the diameter of the cathode-side hole for mounting work 61 and decreases the diameter of the cathode-side connector insertion hole 57, thereby caulking the top plate forming member 24. This firmly fixes the elastic connector 50a at the adjusted position.

Herein, in this way, this embodiment performs the positional adjustment of the elastic connector 50a and then makes up the electricity supply member 3 by stacking the heat conductive sheet 25 in assembly of the electricity supply member 3.

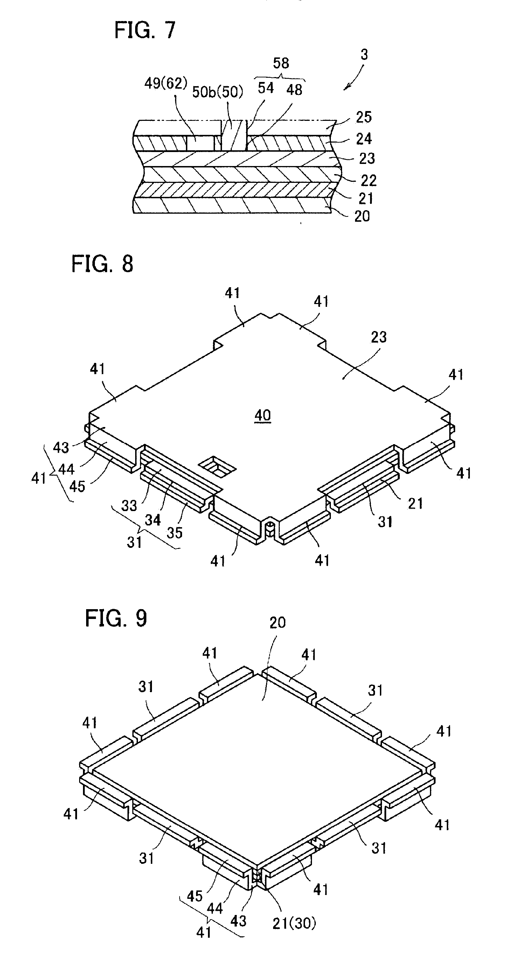

The anode-side hole for mounting work 62 is, as shown in Fig. 7, the other of the holes for mounting work 49 of the top plate forming member 24, or the hole for mounting work 49 different from the hole 49 forming the cathode-side hole for mounting work 61 in the two holes for mounting work 49 (see Fig. 3, etc.), and is a hole penetrating the top plate forming member 24.

The lower end of the anode-side hole for mounting work 62 is also at the same position as the lower end of the anode-side connector insertion hole 58 described above. Specifically, the lower ends of the anode-side hole for mounting work 62 and of the anode-side connector insertion hole 58 are located at the same height as the bottom face of the top plate forming member 24. In other words, the anode-side hole for mounting work 62 and the anode-side connector insertion hole 58 are throughholes penetrating from the upper side (from the top plate forming member 24 or the heat conductive sheet 25) into the bottom face of the top plate forming member 24. In this way, the anode-side hole for mounting work 62 whose lower end is at the same height as that of the anode-side connector insertion hole 58, in which the elastic connector 50b is inserted, is formed slightly away from the hole 58, so that the elastic connector 50b is firmly fixed.

Herein, the way to firmly fix the elastic connector 50b is the same as that to fix the elastic connector 50a to the cathode-side connector insertion hole 57 described above, and thus, the specific description is omitted.

In a part where the cathode-side connecting metal fitting 21 and the anode-side connecting metal fitting 23 overlap, as shown in Fig. 8, the anode-side connecting metal fitting 23 is located above the cathode-side connecting metal fitting 21, with the main body 30 (see Fig. 3) of the cathode-side connecting metal fitting 21 and the main body 40 (see Fig. 3) of the anode-side connecting metal fitting 23 overlapping.

Herein, the leg parts 41 of the anode-side connecting metal fitting 23 located above are longer in vertical length than the leg parts 31 of the cathode-side connecting metal fitting 21 located below. More specifically, the vertical length of the vertical wall part 44 of each of the leg parts 41 of the anode-side connecting metal fitting 23 is longer than that of the vertical wall part 34 of each of the leg parts 31 of the cathode-side connecting metal fitting 21. Thus, the bottom face of the lower plate part 45 located at the lower end of the leg part 41 of the anode-side connecting metal fitting 23 and the bottom face of the lower plate part 35 located at the lower end of the leg part 31 of the cathode-side connecting metal fitting 21 are at the same height in a vertical direction. In other words, the bottom faces of the leg parts 41 of the anode-side connecting metal fitting 23 and the bottom faces of the leg parts 31 of the cathode-side connecting metal fitting 21 are positioned on substantially the same plane.

As shown in Figs. 9 and 10, the leg parts 31 of the cathode-side connecting metal fitting 21 and the leg parts 41 of the anode-side connecting metal fitting 23 are alternately disposed in a circumferential direction of the edge part (the edge part of the electricity supply member 3).

Specifically, when the cathode-side connecting metal fitting 21 and the anode-side connecting metal fitting 23 overlap, as shown in Fig. 10, the cathode-side void parts 36 and the anode-side void parts 46 are alternately arranged in the circumferential direction of the edge part (the edge part of the electricity supply member 3). Additionally, at least a part of each leg part 31 of the cathode-side connecting metal fitting 21 resides in the anode-side void part 46, while at least a part of each leg part 41 of the anode-side connecting metal fitting 23 resides in the cathode-side void part 36. Therefore, when the cathode-side connecting metal fitting 21 and the anode-side connecting metal fitting 23 overlap, the leg parts 31 of the cathode-side connecting metal fitting 21 and the leg parts 41 of the anode-side connecting metal fitting 23 are exposed in a planar view.

In other words, a vertically-projected shape of the leg part 31 of the cathode-side connecting metal fitting 21 is smaller than that of the anode-side void part 46, so that the leg part 31 is located within the vertically projected area of the anode-side void part 46. More specifically, the leg part 31 of the cathode-side connecting metal fitting 21 is located inside the vertically projected area of the anode-side void part 46.

Similarly, a vertically-projected shape of the leg part 41 of the anode-side connecting metal fitting 23 is smaller than that of the cathode-side void part 36, so that the leg part 41 is located within the vertically projected area of the cathode-side void part 36. More specifically, the leg part 41 of the anode-side connecting metal fitting 23 is located inside the vertically projected area of the cathode-side void part 36.

This makes a gap 70 between the leg part 31 of the cathode-side connecting metal fitting 21 and the leg part 41 of the anode-side connecting metal fitting 23. Therefore, the leg parts 31 of the cathode-side connecting metal fitting 21 and the leg parts 41 of the anode-side connecting metal fitting 23 are alternately arranged with intervals (gaps 70) in the circumferential direction of the main body 30.

In this embodiment, a gap 71 is also formed between two of the leg parts 41 located at one corner of the main body 40 of the anode-side connecting metal fitting 23. Therefore, in this embodiment, all the leg parts (the leg parts 31 and the leg parts 41) composed of the leg parts 31 of the cathode-side connecting metal fitting 21 and the leg parts 41 of the anode-side connecting metal fitting 23 are alternately arranged one by one with intervals (the gaps 70 or the gaps 71) in the circumferential direction of the main body 30. Specifically, in the circumferential direction of the main body 30, one leg part 31 of the cathode-side connecting metal fitting 21 and two leg parts 41 of the anode-side connecting metal fitting 23 are aligned in order of succession of the leg part 31 of the cathode-side connecting metal fitting 21, the leg part 41 of the anode-side connecting metal fitting 23, the leg part 41 of the anode-side connecting metal fitting 23, the leg part 31 of the cathode-side connecting metal fitting 21, the leg part 41 of the anode-side connecting metal fitting 23, the leg part 41 of the anode-side connecting metal fitting 23, and so on with intervals.

At this time, as shown in Figs. 3 and 8, the projecting piece part 43 of the leg part 41 of the anode-side connecting metal fitting 23 is located at a position upwardly and outwardly away from the edge end of the main body 30 of the cathode-side connecting metal fitting 21. Meanwhile, as shown in Fig. 9, the vertical wall part 44 of the leg part 41 is located at a position outwardly away from the edge end of the main body 30 of the cathode-side connecting metal fitting 21. That is, the leg parts 41 of the anode-side connecting metal fitting 23 are located away from the cathode-side connecting metal fitting 21, so as not to have direct contact with the cathode-side connecting metal fitting 21.

Further, the leg parts 31 of the cathode-side connecting metal fitting 21 are located downwardly and outwardly away from the edge end of the main body 40 of the anode-side connecting metal fitting 23, so as not to have contact with the anode-side connecting metal fitting 23.

Additionally, as shown in Fig. 3, the insulation film 22 is located between the main body 30 of the cathode-side connecting metal fitting 21 and the main body 40 of the anode-side connecting metal fitting 23, thereby avoiding direct contact with each other.

Consequently, the cathode-side connecting metal fitting 21 and the anode-side connecting metal fitting 23 overlap without direct contact with each other.

When the electricity supply member 3 is assembled, as shown in Figs. 2 and 5, the edge parts of the top plate forming member 24 and the heat conductive sheet 25 are located above the leg parts 31 of the cathode-side connecting metal fitting 21 and the leg parts 41 of the anode-side connecting metal fitting 23. Specifically, the top plate forming member 24 and the heat conductive sheet 25 are larger in a horizontal direction than the main body 30 of the cathode-side connecting metal fitting 21 and the main body 40 of the anode-side connecting metal fitting 23. Thus, when they overlap, the edge parts of the top plate forming member 24 and the heat conductive sheet 25 are located over the leg parts 31 formed at the edge side of the cathode-side connecting metal fitting 21 and the leg parts 41 formed at the edge side of the anode-side connecting metal fitting 23. More specifically, the top plate forming member 24 and the heat conductive sheet 25 are disposed so as to cover the leg parts 31 like eaves at a position upwardly away from the leg parts 31 of the cathode-side connecting metal fitting 21. The bottom face of the top plate forming member 24 and the top faces of the projecting piece parts 43 located at the upper ends of the leg parts 41 of the anode-side connecting metal fitting 23 are in close contact with each other. Thus, the top plate forming member 24 and the heat conductive sheet 25 are disposed so as to cover the lower plate parts 45 like eaves at a position upwardly away from the lower plate parts 45 of the leg parts 41.

The description of the assembly structure of the electricity supply member 3 is completed as described above.

In assembly of the organic EL module 1, as shown in Fig. 2, the electricity supply member 3 and the organic EL panel 2 are electrically connected. Specifically, among the members of the electricity supply member 3, the leg parts 31 of the cathode-side connecting metal fitting 21 are brought into contact with the second electrode parts 12 of the organic EL panel 2, while the leg parts 41 of the anode-side connecting metal fitting 23 are brought into contact with the first electrode parts 11 of the organic EL panel 2. More specifically, the bottom faces (see Fig. 3) of the lower plate parts 35 of the leg parts 31 of the cathode-side connecting metal fitting 21 are brought into contact with the second electrode parts 12, while the bottom faces (see Fig. 3) of the lower plate parts 45 of the leg parts 41 of the anode-side connecting metal fitting 23 are brought into contact with the first electrode parts 11.

That brings the four leg parts 31 of the cathode-side connecting metal fitting 21 into contact with the respective second electrode parts 12. That also brings two of the leg parts 41 of the anode-side connecting metal fitting 23 into contact with one of the first electrode parts 11, so that different pairs consisting of the two leg parts 41 are brought into contact with the four first electrode parts 11 respectively. In short, a plurality of the leg parts 31 formed in the cathode-side connecting metal fitting 21 have contact with the respective second electrode parts 12, while the four pairs each consisting of two of the leg parts 41 formed in the anode-side connecting metal fitting 23 have contact with the respective first electrode parts 11.

When electrically connected in this way, the electricity supply member 3 and the organic EL panel 2 are housed inside the frame 4, so that the organic EL module 1 is assembled. At this time, the top face of the frame 4 and the top face of the electricity supply member 3 are substantially in the same plane (not shown). Specifically, the top face of the upper flange 4b of the frame 4 and the top face of the heat conductive sheet 25 of the electricity supply member 3 are substantially in the same plane.

Further, at this time, the flexible frame 4 is attached to the electricity supply member 3 and the organic EL panel 2 so as to fasten those. Specifically, the frame 4 and predetermined parts of the electricity supply member 3 and the organic EL panel 2 are in close contact (or substantially close contact) with each other with no gap (or substantially no gap) between them under blocking condition.

More specifically, the frame 4 is in close contact (or substantially close contact) with the edge parts of the top plate forming member 24 and the heat conductive sheet 25 of the electricity supply member 3. Further, the top face of the inner projecting part 4c of the frame 4 is in close contact (or substantially close contact) with the bottom face (where the light-emitting face is positioned) of the organic EL panel 2. Thus, in the organic EL module 1 in this embodiment, the frame 4 covers the cathode-side connecting metal fitting 21 and the anode-side connecting metal fitting 23, thereby protecting the members from being exposed outside and preventing water drops from entering a part where the cathode-side connecting metal fitting 21 and the anode-side connecting metal fitting 23 are disposed.

In this embodiment, the cathode-side connecting metal fitting 21 and the anode-side connecting metal fitting 23, each of which is formed of a copper foil bent in a predetermined shape, are used as wiring materials for the electricity supply member 3. The wiring materials are produced more cheaply than a wiring material such as a flat cable. Further, according to such a cathode-side connecting metal fitting 21 and anode-side connecting metal fitting 23, the cathode-side connecting metal fitting 21 and the anode-side connecting metal fitting 23 each can serve as a heat diffusion medium like the above-mentioned heat equalizing plate 20. Specifically, heat generated in the light-emitting face in driving of the organic EL panel 2 is conducted to the cathode-side connecting metal fitting 21 and the anode-side connecting metal fitting 23, whereby the heat is equalized planarly and evenly. That prevents heat from being locally concentrated more certainly.

The above-mentioned first embodiment illustrates an example of the heat equalizing plate 20 and the top plate forming member 24 each being a plate-like shape, but the present invention is not limited thereto. They each can be thinner so as to be a foil-like shape. The foil-like shape makes a total thickness of the organic EL module 1 even thinner.

Additionally, the cathode-side connecting metal fitting 21, the insulation film 22, the anode-side connecting metal fitting 23, and the heat conductive sheet 25 each are not limited to a foil-like shape or a film-like shape and may be a plate-like shape, but in view of making the total thickness of the organic EL module 1 thin, they are also preferably a foil-like shape.

Herein, in a case of a plate-like shape, the cathode-side connecting metal fitting 21 and the anode-side connecting metal fitting 23 each may be formed by bending a metal plate previously punched in a predetermined shape. Alternatively, in a case of a foil-like shape, the cathode-side connecting metal fitting 21 and the anode-side connecting metal fitting 23 each may be shaped by pressing a metal foil previously punched in a predetermined shape onto the other members when the members are stacked to make up the electricity supply member 3.

The above-mentioned first embodiment illustrates an example in which a plurality of leg parts 31 formed in the cathode-side connecting metal fitting 21 are brought into contact with the respective second electrode parts 12 and the pairs each consisting of two leg parts 41 formed in the anode-side connecting metal fitting 23 are brought into contact with the respective first electrode parts 11.

In other words, the cathode-side connecting metal fitting 21 and/or the anode-side connecting metal fitting 23 of the present invention may have a plurality of contacts (leg parts) with the electrodes in the organic EL panel 2. A predetermined number of contacts among the plurally formed contacts may constitute a unit of contacts. Each contact or each unit of contacts may have contact with the electrode in the organic EL panel 2 at a different position.

The first embodiment described above illustrates an example in which each of the gaps 71 is formed between two leg parts 41 located at the corner among the eight leg parts 41 formed in the anode-side connecting metal fitting 23. However, the present invention is not limited thereto and the leg parts 41 in contact with the same first electrode part 11 may be in contact with each other. In other words, the gap 71 is not necessary to be formed between two leg parts 41 located at the corner.

The first embodiment described above illustrates an example in which a metal fitting having the main body 30 of a substantially square shape in a planar view and the leg parts 31 respectively formed adjacent to the centers in the longitudinal direction of the four sides located at the edge end of the main body 30 serves as the cathode-side connecting metal fitting 21, while a metal fitting having the main body 40 of a substantially square shape in a planar view and the leg parts 41 respectively formed adjacent to the both ends in the longitudinal direction of the four sides located at the edge end of the main body 40 serves as the anode-side connecting metal fitting 23. However, the present invention is not limited thereto. The metal fitting employed as the cathode-side connecting metal fitting 21 in the above-mentioned example may be used as an anode-side metal fitting, whereas the metal fitting employed as the anode-side connecting metal fitting 23 in the above-mentioned example may be used as a cathode-side metal fitting. In short, the selection as to which shape of a metal fitting among the two metal fittings is used as the anode side (or the cathode side) may be appropriately changed.

At this time, the metal fitting located above may be used as a cathode-side metal fitting to be connected to the second electrode parts 12, while the metal fitting located below may be used as an anode-side metal fitting to be connected to the first electrode parts 11. Accordingly, a height of each metal fitting may be appropriately changed. That is, a length in a vertical direction of the vertical wall part 34 of the leg part 31 (the vertical wall part 44 of the leg part 41) of the metal fitting may be appropriately changed.

The first embodiment described above illustrates an example in which the elastic connector 50 is used as the electric wire, but the present invention is not limited thereto. It is possible to use a linearly extended member such as a cord as the electric wire, for example. That is, each component constituting the electricity supply member 3 is not required to have a hole for inserting a connector and a hole for mounting a connector.

Next, an organic EL module 501 in a second embodiment of the present invention and a power supply structure made up of an organic EL module 501 in the second embodiment of the present invention will be described in detail below, making reference to the attaching figures. In the description below, directions from front to rear, up to down, and right to left are described on the basis of a normal installation state shown in Fig. 11, unless otherwise specifically noted. Specifically, the description is based on an orientation of an organic EL panel 502 (organic EL device) located below.

The organic EL module 501 in this embodiment is used as lighting equipment In particular, the organic EL module 501 is, as shown in Fig. 11, preferably used in such a manner that a plurality of the organic EL modules 501 are placed without gaps so as to have a planar expanse.

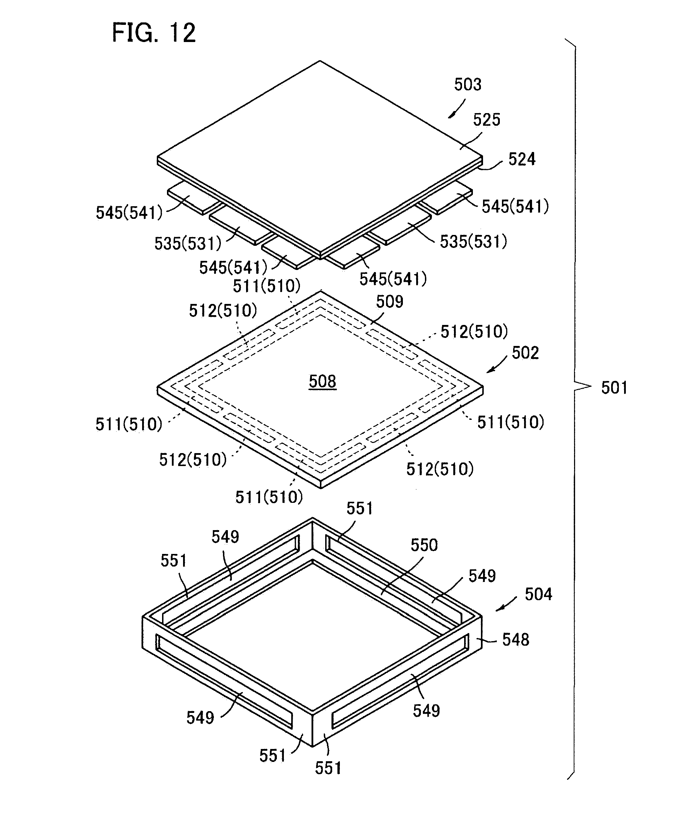

The organic EL module 501, as shown in Fig. 12, mainly consists of the organic EL panel 502, an electricity supply member 503, and a frame 504.

The organic EL panel 502 has a layered structure formed of a transparent electrode (first electrode layer) serving as an anode, an organic light-emitting layer containing a fluorescent material using organic compound, and a metal electrode (second electrode layer) serving as a cathode and stacked on a transparent substrate having a planar expanse and formed of a material such as a flat glass plate or a flat plastic film (not shown as to each layer and layer configuration). The transparent electrode, the organic light-emitting layer, and the metal electrode are sealed by a member such as a glass sealant so that the organic light-emitting layer is not exposed to oxygen.

The organic EL panel 502 is configured so as to emit light from the organic light-emitting layer by supplying power to the transparent electrode and the metal electrode. Herein, the transparent electrode is formed of a material such as ITO (indium tin oxide) and has a light permeability. Hence, the transparent electrode and the substrate located below the organic light-emitting layer each are transparent and have light permeability, so that light emitted from the organic light-emitting layer is emitted downwardly and outwardly.

The organic EL panel 502 is configured by a light emitting part 508 having a substantially square shape in a planar view and located in a center thereof and a peripheral part 509 annularly surrounding the light emitting part 508.

The light emitting part 508 is a light emission region having a substantially square shape in a planar view when power is supplied to the electrodes (the transparent electrode and the metal electrode), the whole bottom face of the light emitting part 508 serves as a light emitting face of the organic EL panel 502.

The peripheral part 509 is a non-emission region when power is supplied to the electrodes (the transparent electrode and the metal electrode). The peripheral part 509 includes electrode parts 510 serving as electric contacts to the outside.

The electrode parts 510 consist of first electrode parts 511 electrically connected to the transparent electrode and second electrode parts 512 electrically connected to the metal electrode, both of which extend in a direction containing components of a thickness direction of the organic EL panel 502 (from inside to outside).

Specifically, the first electrode parts 511 and the second electrode parts 512 are mostly located within the organic EL panel 502 and partly exposed to outside of the organic EL panel 502. They extend from inside to outside of the organic EL panel 502 and along a thickness direction of the organic EL panel 502.

The first electrode parts 511 occupy a part of an upper face of the peripheral part 509 and consist of a plurality of regions each having a substantially L shape in a planar view on the upper face of the peripheral part 509.

The second electrode parts 512 also occupy a part of the upper face of the peripheral part 509 and consist of a plurality of regions each having a substantially rectangular shape in a planar view on the upper face of the peripheral part 509.

The substantially L-shaped regions of the first electrode parts 511 and the substantially rectangular-shaped regions of the second electrode parts 12 are annularly and continuously arranged with an interval. More specifically, the first electrode parts 511 consist of four regions each having a substantially L shape in a planar view, which are located at the outer sides of four corners of the light emitting part 508. Each of the substantially rectangular-shaped regions of the second electrode parts 512 is located between the substantially L-shaped regions. In short, the first electrode parts 511 (regions formed by the first electrode parts 511) and the second electrode parts 512 (regions formed by the second electrode parts 512) are alternately located at a predetermined distance in a circumferential direction of the peripheral part 509.

The electricity supply member 503 is located between an external power source not shown and the organic EL panel 502 and forms an electric supply path from the external power source to the organic EL panel 502.

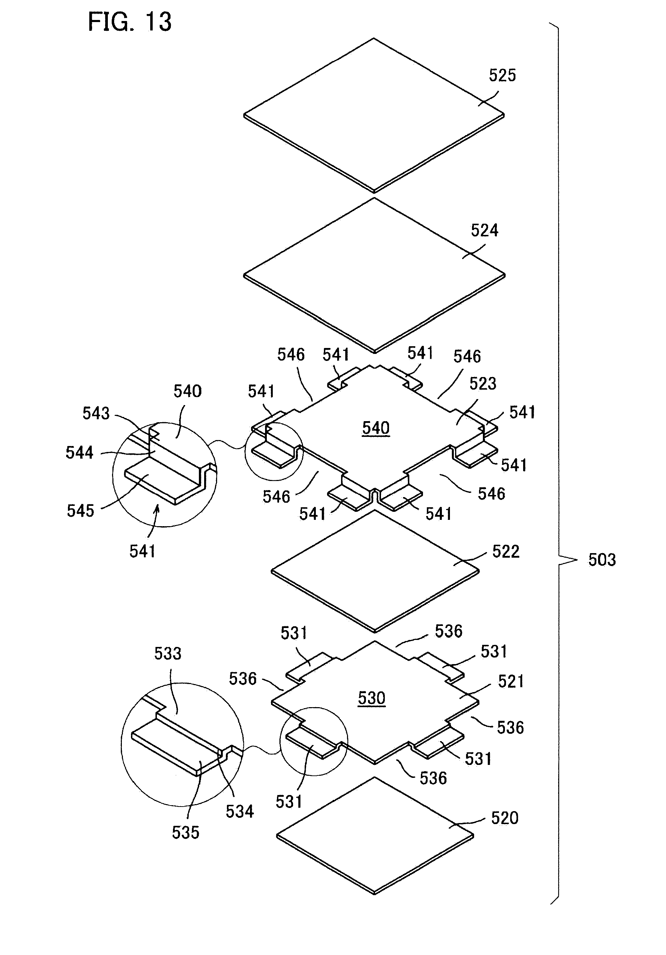

The electricity supply member 503 is, as shown in Fig. 13, formed of a heat equalizing plate 520, a cathode-side connecting metal fitting 521 (first conducting member, first power supply member), an insulation film 522 (insulation layer), an anode-side connecting metal fitting 523 (second conducting member, second power supply member), a top plate forming member 524 (planar body, module member), and a heat conductive sheet 525 stacked in order from the organic EL panel 502 side (bottom side).

The heat equalizing plate 520 is a flat-plate member having a substantially square shape in a planar view and is made of a material having high heat conductivity such as carbon. The heat equalizing plate 520 is disposed on a projection surface of a member thickness direction (vertical direction) of the light emitting part 508, thereby indirectly covering the entire surface of a light-emitting face (bottom face of the light emitting part 508). In other words, it covers an entire surface of a face which faces the light-emitting face. Heat generated in the light-emitting face in driving of the organic EL panel 502 is conducted to the heat equalizing plate 20, whereby the heat is equalized planarly and evenly. Consequently, it is possible to prevent heat from being locally concentrated, which achieves no light emission defect due to heat.

The cathode-side connecting metal fitting 521 is made of a metal having a good electric conductivity such as copper and formed by bending a metal foil (or metal plate) previously punched in a predetermined shape. This embodiment employs a tin-plated copper foil as the metal foil. The cathode-side connecting metal fitting 521 includes a main body 530 of a flat plate having a substantially square shape in a planar view and leg parts 531.

The leg parts 531 are formed integrally with sides that form an outer edge of the main body 530. In this embodiment, the leg parts 531 are formed in a plural number, with one leg part 531 formed at each of four sides of the main body 530. Specifically, the leg parts 531 are each located adjacent to a center in a longitudinal direction of each side and formed in a plural number in a circumferential direction of the main body 530 with an interval.

Each of the leg parts 531 is integrally formed of a projecting piece part 533 of a substantially rectangular flat plate projecting outwardly from the outer edge of the main body 530 in a horizontal direction, a vertical wall part 534 hanging downwardly from an outer end of the projecting piece part 533, and a lower plate part 535 of a substantially rectangular flat plate outwardly projecting from a lower end of the vertical wall part 534. In other words, the outer end of the projecting piece part 533 is bent downwardly to form the vertical wall part 534 and the lower end of the vertical wall part 534 is bent outwardly to form the lower plate part 535. Consequently, the lower plate part 535 is located outward away from the main body 530 and downward from a bottom face of the main body 530.

As described above, the leg parts 531 of the cathode-side connecting metal fitting 521 are formed at the four sides of the main body 530 respectively, and each located adjacent to the center in the longitudinal direction of each side. Therefore, a part where the leg part 531 is formed in the edge part of the cathode-side connecting metal fitting 521 protrudes outward of its periphery. In the edge part of the cathode-side connecting metal fitting 521, edge ends of parts where the leg parts 531 are not formed are located inward of its periphery (where the leg parts 531 are formed). In other words, it can be also said that a part of the edge parts of the cathode-side connecting metal fitting 521 is missing by partial cutout. The void parts, or the regions adjacent to outside of the edge ends located inward of its periphery, serve as cathode-side void parts 536 (first power supply member void parts).

The cathode-side void parts 536 are, as shown in Fig. 13, located adjacent to the corners of the main body 530 and each have a substantially L shape in a planar view (see Fig. 16, etc). Specifically, each of the cathode-side void parts 536 extends along a circumferential direction of the edge part of the cathode-side connecting metal fitting 521. Each of the parts 536 also extends while partially bent at a substantially right angle. The cathode-side void parts 536 consist of a plurality of the parts 536 and more specifically, four cathode-side void parts 536 are arranged adjacent to the four corners of the main body 530 respectively. The cathode-side void parts 536 are located in a circumferential direction of the edge part of the cathode-side connecting metal fitting 521 with an interval.

The insulation film 522 is a resin film having excellent smoothness, heat resistance, and electric insulation and can suitably employ a PET (polyethylene-terephthalate) film.

The anode-side connecting metal fitting 523 is made of a metal having a good electric conductivity such as copper and formed by bending a metal foil (or a metal plate) previously punched in a predetermined shape. This embodiment employs a tin-plated copper foil as the metal foil. Specifically, the anode-side connecting metal fitting 523 is formed by a material and method similar to the cathode-side connecting metal fitting 521 described above, but has a shape different from the cathode-side connecting metal fitting 521.

The anode-side connecting metal fitting 523 includes a main body 540 of a flat plate having a substantially square shape in a planar view and leg parts 541.

The leg parts 541 are formed integrally with sides that form an outer edge of the main body 540. In this embodiment, a plurality of leg parts 541 are formed at the respective four sides of the main body 540. Specifically, two leg parts 541 are located adjacent to both ends in a longitudinal direction of each side, respectively. In other words, each of the leg parts 541 is formed adjacent to the corner of the main body 540. In this embodiment, a gap 571 (see Fig. 16, etc.) is formed between the two leg parts 541 located at each corner. In short, the leg parts 541 are located adjacent to both ends in the longitudinal direction of each side respectively and formed in a plural number in the circumferential direction of the main body 540 with an interval.

Each of the leg parts 541 is integrally formed of a projecting piece part 543 of a substantially rectangular flat plate projecting outwardly from the outer edge of the main body 540 in a horizontal direction, a vertical wall part 544 formed by bending an outer end of the projecting piece part 543 downwardly and hanging downwardly from the outer end of the projecting piece part 543, and a lower plate part 545 of a substantially rectangular flat plate projecting outwardly from a lower end of the vertical wall part 544. Consequently, the lower plate part 545 is located outward away from the main body 540 and downward from a bottom face of the main body 540.

Herein, as described above, two leg parts 541 of the anode-side connecting metal fitting 523 are formed at each of the four sides of the main body 540. The two leg parts 541 are formed adjacent to the both ends in the longitudinal direction of each side, respectively. Therefore, a part where the leg part 541 is formed in the edge part of the anode-side connecting metal fitting 523 protrudes outward of its periphery. In the edge part of the anode-side connecting metal fitting 523, edge ends of parts where the leg parts 541 are not formed are located inward of its periphery (where the leg parts 541 are formed). In other words, it can be also said that a part of the edge part of the anode-side connecting metal fitting 523 is missing by partial cutout. The void parts, or the regions adjacent to outside of the edge ends located inward of its periphery, serve as anode-side void parts 546 (second power supply member void parts).

The anode-side void parts 546 each are, as shown in Fig. 13, located adjacent to a center in the longitudinal direction of each side constituting the edge part of the main body 540 and have a substantially rectangular shape in a planar view (see Fig. 16). The anode-side void parts 546 consist of a plurality of the parts 546 and more specifically, four anode-side void parts 546 are arranged adjacent to positions between the four corners of the main body 540 respectively. The four anode-side void parts 546 are located in a circumferential direction of the edge part of the anode-side connecting metal fitting 523 with an interval.

The top plate forming member 524 is made of a material such as metal or alloy that is attracted to a magnet. This embodiment employs a substantially square flat-plate member made of iron or a metal containing iron as a major component. In other words, it also can be said that the top plate forming member 524 is made of a magnetic body or a material containing a magnetic body.

With such a top plate forming member 524, the organic EL module 501 in this embodiment can be attached to a ceiling, a wall, or the like via a magnetic mounting tool such as a permanent magnet or a mounting tool having a magnetic member.

The top plate forming member 524 serves also as a heat conductive medium in driving of the organic EL panel 502. Specifically, the top plate forming member 524 forms a part of a heat transfer path from the organic EL panel 502 toward outside when heat generated in the organic EL panel 502 is dissipated via a member such as the frame 504 and the heat conductive sheet 525 to outside.

The heat conductive sheet 525 is made of a material having an excellent heat conductivity and flexibility and has a substantially square shape in a planar view (such as Sarcon EGR-11F, Sarcon TR, and Sarcon GSR made by Fuji Polymer Industries Co., Ltd., for example).

The heat conductive sheet 525 is to be positioned between the top plate forming member 524 and a fitting member (plate-like frame, for example) not shown fixed to a ceiling, a wall, or the like when the organic EL module 501 is assembled. The heat conductive sheet 525 is excellent in flexibility as described above, so as to be able to fill a gap generated between the top plate forming member 524 and the fitting member without strongly pressing the organic EL module 501 onto the fitting member. Further, the heat conductive sheet 525 is in close contact with a top face of the top plate forming member 524 in a wide area. This efficiently transfers heat from the top plate forming member 524 to the fitting member.

The frame 504 is, as shown in Fig. 12, a flexible frame body made of an appropriate material such as silicon resin. More specifically, the frame 504 is constituted by a main body 548 of a substantially square cylinder, openings 549 formed at sides of the main body 548 so as to communicate between an inside and an outside, and an inner projecting part 550 formed adjacent to a lower end of an inner peripheral surface of the main body 548.

The main body 548 is annularly and continuously formed so that vertical wall parts 551 each of a standing rectangular flat plate make up a substantially hollow square shape in a planar view.

Each of the openings 549 is a throughhole having a substantially rectangular opening shape and being formed in each of the vertical wall parts 551. The openings 549 are formed at the four sides of the frame 504, respectively, and open to different directions.

The inner projecting part 550 is a flat plate projecting inwardly from the lower end of the inner peripheral surface of the main body 548. The inner projecting part 550 is also annularly and continuously formed in the circumferential direction of the main body 548 so as to have a substantially hollow square shape in a planar view.

Next, an assembly structure of the electricity supply member 503 will be described in detail below.

The electricity supply member 503 is, as described above, made up of the heat equalizing plate 520, the cathode-side connecting metal fitting 521, the insulation film 522, the anode-side connecting metal fitting 523, the top plate forming member 524, and the heat conductive sheet 525 stacked from the organic EL panel 502 side (lower side) (see Fig. 13). At this time, predetermined members making up the layered structure are connected via an adhesive material as needed. The adhesive material can suitably employ RTV rubber or a paste-like material having a high heat conductivity.

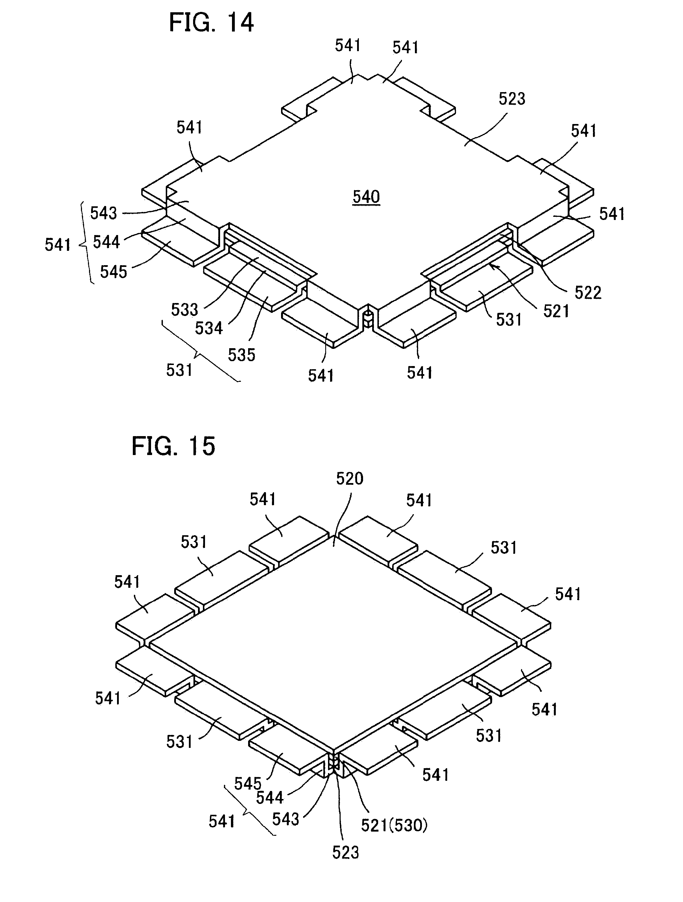

In a part where the cathode-side connecting metal fitting 521 and the anode-side connecting metal fitting 523 overlap, as shown in Fig. 14, the anode-side connecting metal fitting 523 is located above the cathode-side connecting metal fitting 521, with the main body 530 (see Fig. 13) of the cathode-side connecting metal fitting 521 and the main body 540 (see Fig. 13) of the anode-side connecting metal fitting 523 overlapping.

Herein, the leg parts 541 of the anode-side connecting metal fitting 523 located above are longer in vertical length than the leg parts 531 of the cathode-side connecting metal fitting 521 located below. More specifically, the vertical length of the vertical wall part 544 of each of the leg parts 541 of the anode-side connecting metal fitting 523 is longer than that of the vertical wall part 534 of each of the leg part 531 of the cathode-side connecting metal fitting 521. Thus, the bottom face of the lower plate part 545 located at the lower end of the leg part 541 of the anode-side connecting metal fitting 523 and the bottom face of the lower plate part 535 located at the lower end of the leg part 531 of the cathode-side connecting metal fitting 521 are at the same height in a vertical direction. In other words, the bottom faces of the leg parts 541 of the anode-side connecting metal fitting 523 and the bottom faces of the leg parts 531 of the cathode-side connecting metal fitting 521 are positioned on substantially the same plane.

As shown in Figs. 15 and 16, the leg parts 531 of the cathode-side connecting metal fitting 521 and the leg parts 541 of the anode-side connecting metal fitting 523 are alternately disposed in a circumferential direction of the edge part (the edge part of the electricity supply member 503).

Specifically, when the cathode-side connecting metal fitting 521 and the anode-side connecting metal fitting 523 overlap, as shown in Fig. 16, the cathode-side void parts 536 and the anode-side void parts 546 are alternately arranged in the circumferential direction of the edge part (the edge part of the electricity supply member 503). Additionally, at least a part of each leg part 531 of the cathode-side connecting metal fitting 521 resides in the anode-side void part 546, while at least a part of each leg part 541 of the anode-side connecting metal fitting 523 resides in the cathode-side void part 536. Therefore, when the cathode-side connecting metal fitting 521 and the anode-side connecting metal fitting 523 overlap, the leg parts 531 of the cathode-side connecting metal fitting 521 and the leg parts 541 of the anode-side connecting metal fitting 523 are exposed in a planar view.

In other words, a vertically projected shape of the leg part 531 of the cathode-side connecting metal fitting 521 is smaller than that of the anode-side void part 546, so that the leg part 531 is located within the vertically projected area of the anode-side void part 546. More specifically, the leg part 531 of the cathode-side connecting metal fitting 521 is located inside the vertically projected area of the anode-side void part 546.

Similarly, a vertically projected shape of the leg part 541 of the anode-side connecting metal fitting 523 is smaller than that of the cathode-side void part 536, so that the leg part 541 is located within the vertically projected area of the cathode-side void part 536. More specifically, the leg part 541 of the anode-side connecting metal fitting 523 is located inside the vertically projected area of the cathode-side void part 536.

This makes a gap 570 between the leg part 531 of the cathode-side connecting metal fitting 521 and the leg part 541 of the anode-side connecting metal fitting 523. Therefore, the leg parts 531 of the cathode-side connecting metal fitting 521 and the leg parts 541 of the anode-side connecting metal fitting 523 are alternately arranged with intervals (gaps 570) in the circumferential direction of the main body 530.

In this embodiment, a gap 571 is also formed between two of the leg parts 541 located at one corner of the main body 540 of the anode-side connecting metal fitting 523. Therefore, in this embodiment, all the leg parts (the leg parts 531 and the leg parts 541) composed of the leg parts 531 of the cathode-side connecting metal fitting 521 and the leg parts 541 of the anode-side connecting metal fitting 523 are alternately arranged one by one with intervals (the gaps 570 or the gaps 571) in the circumferential direction of the main body 530. Specifically, in the circumferential direction of the main body 530, one leg part 531 of the cathode-side connecting metal fitting 521 and two leg parts 541 of the anode-side connecting metal fitting 523 are aligned in order of succession of the leg part 531 of the cathode-side connecting metal fitting 521, the leg part 541 of the anode-side connecting metal fitting 523, the leg part 541 of the anode-side connecting metal fitting 523, the leg part 531 of the cathode-side connecting metal fitting 521, the leg part 541 of the anode-side connecting metal fitting 523, the leg part 541 of the anode-side connecting metal fitting 523, and so on with intervals.

At this time, as shown in Figs. 13 and 14, the projecting piece part 543 of the leg part 541 of the anode-side connecting metal fitting 523 is located at a position upwardly and outwardly away from the edge end of the main body 530 of the cathode-side connecting metal fitting 521. Meanwhile, as shown in Fig. 14, the vertical wall part 544 of the leg part 541 is located at a position outwardly away from the edge end of the main body 530 of the cathode-side connecting metal fitting 521. That is, the leg parts 541 of the anode-side connecting metal fitting 523 are located away from the cathode-side connecting metal fitting 521, so as not to have direct contact with the cathode-side connecting metal fitting 521.

Further, the leg parts 531 of the cathode-side connecting metal fitting 521 are located downwardly and outwardly away from the edge end of the main body 540 of the anode-side connecting metal fitting 523, so as not to have contact with the anode-side connecting metal fitting 523.

Additionally, as shown in Fig. 13, the insulation film 522 is located between the main body 530 of the cathode-side connecting metal fitting 521 and the main body 540 of the anode-side connecting metal fitting 523, thereby avoiding direct contact with each other.
Consequently, the cathode-side connecting metal fitting 521 and the anode-side connecting metal fitting 523 overlap without direct contact with each other.

When the electricity supply member 503 is assembled, as shown in Figs. 12, the edge parts of the top plate forming member 524 and the heat conductive sheet 525 are located above the leg parts 531 of the cathode-side connecting metal fitting 521 and the leg parts 541 of the anode-side connecting metal fitting 523. Specifically, the top plate forming member 524 and the heat conductive sheet 525 are disposed so as to cover a part of the leg parts 531 nearer the main body 530 side at a position upwardly away from the leg parts 531 of the cathode-side connecting metal fitting 521 (see Fig. 12). The bottom face of the top plate forming member 524 are in close contact with the top faces of the projecting piece parts 543 located at the upper ends of the leg parts 541 of the anode-side connecting metal fitting 523. Further, the top plate forming member 524 and the heat conductive sheet 525 are formed so as to cover a large part of the anode-side connecting metal fitting 523 nearer the main body 540 side, or a part of the lower plate part 545 of the leg part 541 except a part located outside (see Fig. 12)

Specifically, as shown in Figs. 12 and 13, the lower plate part 535 of the leg part 531 of the cathode-side connecting metal fitting 521 and the lower plate part 545 of the leg part 541 of the anode-side connecting metal fitting 523 project outwardly from the sides of the electricity supply member 503. Thus, projecting edges (projecting edges of the lower plate parts 535 and projecting edges of the lower plate parts 545) are located outward of the edge parts of the top plate forming member 524 and the heat conductive sheet 525. In other words, a part of the cathode-side connecting metal fitting 521 and a part of the anode-side connecting metal fitting 523 project outwardly from the sides of the electricity supply member 503.

Next, an assembly structure of the organic EL module 501 provided with such an electricity supply member 503 will be described in detail below.

In assembly of the organic EL module 501, as shown in Fig. 12, the electricity supply member 503 and the organic EL panel 502 are electrically connected. Specifically, among the members of the electricity supply member 503, the leg parts 531 of the cathode-side connecting metal fitting 521 are brought into contact with the second electrode parts 512 of the organic EL panel 502, while the leg parts 541 of the anode-side connecting metal fitting 523 are brought into contact with the first electrode parts 511 of the organic EL panel 502. More specifically, the bottom faces (see Fig. 13) of the lower plate parts 535 of the leg parts 531 of the cathode-side connecting metal fitting 521 are brought into contact with the second electrode parts 512, while the bottom faces (see Fig. 13) of the lower plate parts 545 of the leg parts 541 of the anode-side connecting metal fitting 523 are brought into contact with the first electrode parts 511.

When brought into contact with each other in this way, the cathode-side connecting metal fitting 521 and the second electrode parts 512 form a conducting part to be a path for supplying electricity to the metal electrode of the organic EL panel 502. Specifically, the cathode-side connecting metal fitting 521 and the second electrode part 512 become a path for supplying electricity that extends from outside to the metal electrode of the organic EL panel 502 by contacting of the cathode-side connecting metal fitting 521 with the second electrode parts 512 electrically connected to the metal electrode.

Similarly, when brought into contact with each other, the anode-side connecting metal fitting 523 and the first electrode parts 511 form a conducting part to be a path for supplying electricity to the transparent electrode of the organic EL panel 502. Specifically, the anode-side connecting metal fitting 523 and the first electrode parts 511 become a path for supplying electricity that extends from outside to the transparent electrode of the organic EL panel 502 by contacting of the anode-side connecting metal fitting 523 with the first electrode parts 511 electrically connected to the transparent electrode.

In short, the organic EL module 501 has a structure for supplying electricity to the organic EL panel 502 via a pair of two conducting parts consisting of a first conducting part made up of the cathode-side connecting metal fitting 521 and the second electrode parts 512 and a second conducting part made up of the anode-side connecting metal fitting 523 and the first electrode parts 511.

At this time, the four leg parts 531 of the cathode-side connecting metal fitting 521 are in contact with the respective second electrode parts 512. Meanwhile, two of the leg parts 541 of the anode-side connecting metal fitting 523 have contact with one of the first electrode parts 511, so that different pairs of the leg parts 541 are brought into contact with the four first electrode parts 511, respectively. In short, a plurality of the leg parts 531 formed in the cathode-side connecting metal fitting 521 have contact with the respective second electrode parts 512, while pairs each consisting of two of the leg parts 541 formed in the anode-side connecting metal fitting 523 have contact with the respective first electrode parts 511.

When electrically connected in this way, the electricity supply member 503 and the organic EL panel 502 are housed inside the frame 504, so that the organic EL module 501 is assembled. At this time, the top face of the frame 504 and the top face of the electricity supply member 503 are substantially in the same plane (not shown). Specifically, the top face of the main body 548 of the frame 504 and the top face of the heat conductive sheet 525 of the electricity supply member 503 are substantially in the same plane.

Further, with the electricity supply member 503 and the organic EL panel 502 housed in the frame 504, which is flexible, is attached so as to fasten those. Specifically, the frame 504 and predetermined parts of the electricity supply member 503 and the organic EL panel 502 are in close contact (or substantially close contact) with each other with no gap (substantially no gap) between them under blocking condition.

More specifically, the frame 504 is in close contact (or substantially close contact) with the edge parts of the top plate forming member 524 and the heat conductive sheet 525 of the electricity supply member 503. Further, the top face of the inner projecting part 550 of the frame 504 is in close contact (or substantially close contact) with the bottom face (where the light-emitting face is positioned) of the organic EL panel 502. Thus, in the organic EL module 501 in this embodiment, the frame 504 covers the cathode-side connecting metal fitting 521 and the anode-side connecting metal fitting 523, thereby protecting the members from being exposed outside and preventing water drops from entering a part where the cathode-side connecting metal fitting 521 and the anode-side connecting metal fitting 523 are disposed.

Still further, as shown in Fig. 17, the lower plate parts 535 (see Fig. 13) of the leg parts 531 of the cathode-side connecting metal fitting 521 and the lower plate parts 545 (see Fig. 13) of the leg parts 541 of the anode-side connecting metal fitting 523 are disposed within the openings 549 of the frame 504. The lower plate parts 535 of the cathode-side connecting metal fitting 521 and the lower plate parts 545 of the anode-side connecting metal fitting 523 project outwardly through the openings 549 of the frame 504. More specifically, outer ends of the lower plate parts 535 of the cathode-side connecting metal fitting 521 and the lower plate parts 545 of the anode-side connecting metal fitting 523 are mostly located within the openings 549 and only the outer ends project outwardly through the openings 549.

The lower plate parts 535 of the cathode-side connecting metal fitting 521 and the lower plate parts 545 of the anode-side connecting metal fitting 523 project outwardly from the vicinity of centers in a vertical direction of the openings 549. Thus, the top faces and the bottom faces of the lower plate parts 535 of the cathode-side connecting metal fitting 521 and of the lower plate parts 545 of the anode-side connecting metal fitting 523 are disposed at intervals with between inner peripheral surfaces of the openings 549. In other words, there exist gaps between the inner peripheral surfaces of the opening 549 and the upper and lower parts of the lower plate parts 535 of the cathode-side connecting metal fitting 521 and of the lower plate parts 545 of the anode-side connecting metal fitting 523, respectively.

Herein, as described above, the cathode-side connecting metal fitting 521 becomes a part of the first conducting part for supplying electricity to the metal electrode of the organic EL panel 502. That is, in the organic EL module in the present embodiment, a part of the first conducting part is exposed (slightly projects) outside. Similarly, the anode-side connecting metal fitting 523 becomes a part of the second conducting part for supplying electricity to the transparent electrode of the organic EL panel 502. That is, in the organic EL module in the present embodiment, a part of the second conducting part is also exposed (slightly projects) outside.

In this way, since a part of each conducting part constituting a pair of the conducting parts is exposed outside, the organic EL module 501 in the present embodiment has a structure capable of having direct contact with an external conductive body.

Next, a power supply structure when a plurality of organic EL modules 501 are used by being placed without gaps on a ceiling or the like so as to have a planar expanse will be described below.

In the organic EL module 501 in this embodiment, as shown in Fig. 11, when two organic EL modules 501 are arranged adjacently, only close contact of the respective side faces with each other electrically connects those in parallel.

Specifically, with the side faces of two organic EL modules 501 brought into close contact with each other, as shown in Figs. 18A and B, the lower plate part 535a of the cathode-side connecting metal fitting 521 and the lower plate parts 545a of the anode-side connecting metal fitting 523 both projecting outwardly through the opening 549a of one organic EL module 501a are inserted into the opening 549b of the other organic EL module 501 b.

Meanwhile, the lower plate part 535b of the cathode-side connecting metal fitting 521 and the lower plate parts 545b of the anode-side connecting metal fitting 523 both projecting outwardly through the opening 549b of the other organic EL module 501b are inserted into the opening 549a of the one organic EL module 501a.

Specifically, as shown in Fig. 18B, the opening 549a of the one organic EL module 501a and the opening 549b of the other organic EL module 501b are communicated with each other, thereby forming a space 580. Within the space 580 are arranged the lower plate part 535a of the cathode-side connecting metal fitting 521 and the lower plate parts 545a of the anode-side connecting metal fitting 523 of the one organic EL module 501a and the lower plate part 535b of the cathode-side connecting metal fitting 521 and the lower plate parts 545b of the anode-side connecting metal fitting 523 of the other organic EL module 501b.

Herein, as shown in Figs. 18B and 19, the lower plate part 535a of the cathode-side connecting metal fitting 521 of the one organic EL module 501a and the lower plate part 535b of the cathode-side connecting metal fitting 521 of the other organic EL module 501b overlap. Thus, the cathode-side connecting metal fitting 521 of the one organic EL module 501a and the cathode-side connecting metal fitting 521 of the other organic EL module 501 b are in direct contact with each other, so as to be electrically connected.

Fig. 19 illustrates a state in which the lower plate parts 535 are greatly inclined for explanation. However, since the cathode-side connecting metal fittings 521 each are a foil shape (or a plate shape) and very thin, the lower plate parts 535 are not actually greatly inclined like this when the lower plate parts 535 overlap.

Meanwhile, as shown in Figs. 18B and 20, the lower plate parts 545a of the anode-side connecting metal fitting 523 of the one organic EL module 501a and the lower plate parts 545b of the anode-side connecting metal fitting 523 of the other organic EL module 501b overlap, respectively. Thus, the anode-side connecting metal fitting 523 of the one organic EL module 501 a and the anode-side connecting metal fitting 523 of the other organic EL module 501 b are in direct contact with each other, so as to be electrically connected.

Fig. 20 illustrates a state in which the lower plate parts 545 are greatly inclined for explanation. However, since the anode-side connecting metal fittings 523 each are a foil shape (or a plate shape) and very thin, the lower plate parts 545 are not actually greatly inclined like this when the lower plate parts 545 overlap.

Further, as shown in Fig. 18B, a part where the lower plate parts 535 of the respective cathode-side connecting metal fittings 521 of the one organic EL module 501a and of the other organic EL module 501 b overlap and a part where the lower plate parts 545 of the respective anode-side connecting metal fittings 523 of the one organic EL module 501a and of the other organic EL module 501b overlap are separated from each other with a gap 81.

In short, the part where the cathode-side connecting metal fittings 521 of the one organic EL module 501a and the other organic EL module 501b overlap is not in contact with the part where the anode-side connecting metal fittings 523 of those overlap. That is to say, the cathode-side connecting metal fitting 521 a of the one organic EL module 501a and the anode-side connecting metal fitting 523b of the other organic EL module 501b, or alternatively, the anode-side connecting metal fitting 523a of the one organic EL module 501a and the cathode-side connecting metal fitting 521b of the other organic EL module 501b are designed to not be in contact with each other.

This electrically connects the anodes of two adjacently-disposed organic EL modules 501 (the organic EL module 501a and the organic EL module 501b) to each other and the cathodes of those to each other, so that the two organic EL modules 501 are electrically connected in parallel.

In contrast, in order to electrically connect two adjacently-disposed organic EL modules 501 to each other in series, a conductive body such as a lead wire or a foil-shaped connector is placed between the two organic EL modules 501, so as to electrically connect the anode of the one organic EL module 501a with the cathode of the other organic EL module 501b and to electrically connect the cathode of the one organic EL module 501a with the anode of the other organic EL module 501b. More specifically, the cathode-side connecting metal fitting 521a of the one organic EL module 501a and the anode-side connecting metal fitting 523b of the other organic EL module 501b, or alternatively, the anode-side connecting metal fitting 523a of the one organic EL module 501a and the cathode-side connecting metal fitting 521b of the other organic EL module 501b are electrically connected.

In this way, in the organic EL module 501 in the present embodiment, when a plurality of organic EL modules 501 are placed without gaps so as to have a planar expanse, adjacent organic EL modules 501 can be electrically connected in parallel or in series. Therefore, as shown in Fig. 21 for example, parallelly-connected module rows 585 each constituted by adjacent organic EL modules 501 electrically connected in parallel may be electrically connected in series. Alternatively, as shown in Fig. 22, serially-connected module rows 586 each constituted by adjacent organic EL module 501 electrically connected in series may be electrically connected in parallel.

More specifically, though not specifically limited, referring to Figs. 23 and 24, one parallelly-connected module row 585 is formed of N (four in this embodiment) of the organic EL modules 501. M (three in this embodiment) of the parallelly-connected module rows 585 are placed in rows, so as to be used as lighting equipment including N x M of modules 501 with a planar expanse.

At this time, as shown in Fig. 24, among two adjacent parallelly-connected module rows 585, the organic EL modules 501 belonging to a parallelly-connected module row 585a of the first row and the organic EL modules 501 belonging to a parallelly-connected module row 585b of the second row are electrically connected in series. Further, the organic EL modules 501 belonging to the parallelly-connected module row 585b of the second row and the organic EL modules 501 belonging to a parallelly-connected module row 585c of the third row are electrically connected in series, and so on. In this way, the organic EL modules 501 belonging to two adjacent parallelly-connected module rows 585 are electrically connected in series in order.

More specifically, when the organic EL modules 501 belonging to the parallelly-connected module row 585a of the first row consist of a first organic EL module 501α, a second organic EL module 501β, and so on from a distal end to a proximal end in an extending direction L of the row and when, similarly, the organic EL modules 501 belonging to the parallelly-connected module row 585b of the second row consist of a first organic EL module 501α, a second organic EL module 501β, and so on from the distal end to the proximal end in the extending direction L of the row, the first organic EL modules 501α are electrically connected to each other in series, the second organic EL modules 501β are electrically connected to each other in series, and so on. Moreover, similarly in the cases of the parallelly-connected module row 585b of the second row and a parallelly-connected module row 585c of the third row, the first organic EL modules 501α are electrically connected to each other in series, the second organic EL modules 501β are electrically connected to each other in series, and so on. In short, respective two modules 501 adjacently located in an arrangement direction W among the organic EL modules 501 belonging to two adjacent parallelly-connected module rows 585 are electrically connected to each other in series. This forms lighting equipment having a planar expanse.

The above-mentioned second embodiment illustrates an example in which the respective organic EL modules 501 belonging to adjacent parallelly-connected module rows 585 are electrically connected to each other in series when the parallelly-connected module rows 585 are arranged in rows. Further, adjacent organic EL modules 501 are electrically connected to each other in series via a conductive body such as a lead wire or a foil-shaped connector when the adjacent organic EL modules 510 are electrically connected to each other in series. However, the present invention is not limited to the above-mentioned way to electrically connect the organic EL modules 501 of the present invention to each other in series. As shown in Fig. 25, for example, another parallelly-connected module row 185 constituted by organic EL modules 101 each including an organic EL panel (not shown) different from the above-mentioned second embodiment may be disposed between the two parallelly-connected module rows 585 (the parallelly-connected module row 585a and the parallelly-connected module row 585b).

Now, the organic EL module 101 belonging to the other parallelly-connected module row 185 will be described in detail below. The organic EL panel (not shown) included in the organic EL module 101 is different from the organic EL panel 502 described above in that a part corresponding to the first electrode part 511 (see Fig. 12) is electrically connected to the metal electrode serving as a cathode, while a part corresponding to the second electrode part 512 (see Fig. 12) is electrically connected to the transparent electrode serving as an anode. In other words, in the organic EL panel 502 in the above-mentioned second embodiment, the first electrode part 511 serves an anode and the second electrode part 512 serves as a cathode. In contrast, the organic EL panel (not shown) included in the organic EL module 101 is different from the above-mentioned panel 502 in that the part corresponding to the first electrode part 511 serves as a cathode and the part corresponding to the second electrode part 512 serves as an anode. Consequently, as shown in Fig. 25, in the organic EL module 101, the cathode-side connecting metal fitting 521 of the electricity supply member 503 serves as an anode-side metal fitting and the anode-side connecting metal fitting 523 thereof serves as a cathode-side metal fitting. That is, as shown in Fig. 25, in the organic EL module 101, the polarities of the cathode-side connecting metal fitting 521 exposed outside and the anode-side connecting metal fitting 523 exposed outside are different from those in the organic EL module 501.

Therefore, the organic EL module 101 and the above-mentioned organic EL module 501 are connected to each other in the same manner as connecting the above-mentioned organic EL modules 501 in parallel. Specifically, the cathode-side connecting metal fittings 521 of the organic EL module 101 and the organic EL module 501 are brought into contact with each other and the anode-side connecting metal fittings 523 of the organic EL module 101 and the organic EL module 501 are brought into contact with each other, so that the modules 101 and 501 are electrically connected in series. Therefore, lighting equipment (see Fig. 25) having the same electrical connection as that of the lighting equipment shown in Fig. 24 is made up without an external conductive body such as a lead wire or a foil-shaped connector.

The above-mentioned second embodiment has a structure in which a part of the cathode-side connecting metal fitting 521, which serves as a first conducting member, and a part of the anode-side connecting metal fitting 523, which serves as a second conducting member, are exposed outside so as to have direct contact with an external conductive body (such as a metal fitting of another organic EL module, a lead wire, or a foil-shaped connector), but the present invention is not limited thereto. It is possible, for example, to have a structure in which the first electrode parts 511 and the second electrode parts 512 of the organic EL panel 502 extend outside of the frame 504 so as to have direct contact with an external conductive body.

In other words, in a case where a pair of the conducting parts consisting of the first conducting part, which is constituted by the cathode-side connecting metal fitting 521 and the second electrode parts 512, and the second conducting part, which is constituted by the anode-side connecting metal fitting 523 and the first electrode parts 511, supplies electricity to the organic EL panel 502 as described above, it is only necessary to bring either part of each conducting part into direct contact with an external conductive body.

Though the description is omitted in the above-mentioned second embodiment, when a plurality of organic EL modules 501 are placed without gaps so as to have a planar expanse, the other organic EL modules 501 and/or the openings 549 located at a position at which they have no contact with a member such as an external power supply member can be closed by a member such as a lid. That prevents water drops or the like from entering inside of the organic EL modules 501 through the openings 549 unutilized for electrical connection.

The above-mentioned second embodiment illustrates an example of the heat equalizing plate 520 and the top plate forming member 524 each being a plate-like shape, but the present invention is not limited thereto. Each of them can be thinner so as to be a foil-like shape. The foil-like shape makes a total thickness of the organic EL module 501 further thinner.

Additionally, the cathode-side connecting metal fitting 521, the insulation film 522, the anode-side connecting metal fitting 523, the heat conductive sheet 525 each are not limited to a foil-like shape or a film-like shape and may be a plate-like shape, but in view of making the total thickness of the organic EL module 501 small, each of them is also preferably a foil-like shape.

Herein, in a case of being a plate-like shape, each of the cathode-side connecting metal fitting 521 and the anode-side connecting metal fitting 523 may be formed by bending a metal plate previously punched in a predetermined shape. Alternatively, in a case of being a foil-like shape, each of the cathode-side connecting metal fitting 521 and the anode-side connecting metal fitting 523 may be shaped by pressing a metal foil previously punched in a predetermined shape onto the other members when the other members are stacked so as to make up the electricity supply member 503.

The above-mentioned second embodiment illustrates an example in which a plurality of leg parts 531 formed in the cathode-side connecting metal fitting 521 are brought into contact with the respective second electrode parts 512 and the pairs each consisting of two leg parts 541 formed in the anode-side connecting metal fitting 523 are brought into contact with the respective first electrode parts 511.

In other words, the cathode-side connecting metal fitting 521 and/or the anode-side connecting metal fitting 523 of the present invention may have a plurality of contacts (leg parts) with the electrodes of the organic EL panel 502. A predetermined number of contacts among the plurally formed contacts may constitute a unit of contacts. Each contact or each unit of contacts may have contact with the electrodes of the organic EL panel 502 at different positions.

The second embodiment described above illustrates an example in which each of the gaps 571 is formed between two leg parts 541 located at the corner among the eight leg parts 541 formed in the anode-side connecting metal fitting 523. However, the present invention is not limited thereto and the leg parts 541 in contact with the same first electrode part 511 may be in contact with each other. In other words, the gap 571 is not necessary to be formed between two leg parts 541 located at the corner.

The second embodiment described above illustrates an example in which a metal fitting formed of the main body 530 of a substantially square shape in a planar view and the leg parts 531 formed adjacent to the centers in the longitudinal direction of the four sides located at the edge end of the main body 530 serves as the cathode-side connecting metal fitting 521, while a metal fitting formed of the main body 540 of a substantially square shape in a planar view and the leg parts 541 formed adjacent to the centers in the longitudinal direction of the four sides located at the edge end of the main body 540 serves as the anode-side connecting metal fitting 523.

However, the present invention is not limited thereto. An anode-side metal fitting may have the shape of the metal fitting employed as the cathode-side connecting metal fitting 521 in the above-mentioned example, whereas a cathode-side metal fitting may have the shape of the metal fitting employed as the anode-side connecting metal fitting 523. In short, the selection as to which shape of a metal fitting among the two metal fittings to be used as the anode side (or the cathode side) may be appropriately changed.

At this time, the metal fitting located above may be used as a cathode-side metal fitting to be connected to the second electrode parts 512, while the metal fitting located below may be used as an anode-side metal fitting to be connected to the first electrode parts 511. According to that, a height of each metal fitting may be appropriately changed. That is, a length in a vertical direction of the vertical wall part 534 of the leg part 531 (the vertical wall part 544 of the leg part 541) of the metal fitting may be appropriately changed.

The above-mentioned second embodiment illustrates an example in which the lower plate parts 535 of the leg parts 531 of the cathode-side connecting metal fitting 521 and the lower plate parts 545 of the leg parts 541 of the anode-side connecting metal fitting 523 project outwardly through the openings 549 of the frame 504. At this time, the above-mentioned second embodiment makes each lower plate part (the lower plate part 535, the lower plate part 545) project along a horizontal direction to be slightly exposed outside, but the present invention is not limited thereto. For example, as shown in Fig. 26, each lower plate part may project outwardly in a horizontal direction with a projecting edge side of a part exposed outside bent upwardly. In short, it is possible to form an organic EL module 105 including the part exposed outside having a shape projecting in a substantially L-shaped cross section.

In the organic EL module 105, lower plate parts 135 of the cathode-side connecting metal fitting and the anode-side connecting metal fitting each are formed of a distal end plate 135a of a rectangular flat plate projecting outwardly along a horizontal direction and a vertical wall part 135b of an upright rectangular flat plate projecting upwardly from an outer end of the distal end part 135a. The inner peripheral surface of the vertical wall part 135b has contact with the side face of the frame 504. According to such the organic EL module 105, when a plurality of organic EL modules 105 are disposed adjacently, only bringing the side face of one organic EL module 105 into contact with that of another organic EL module 105 brings the outside faces of the vertical wall parts 135b of the organic EL module 105 into plane contact with each other. In short, merely pressing one organic EL module 105 onto another organic EL module 105 allows electrical contact, so that the organic EL modules 105 are readily connected.

Alternatively, unlike in the case in Fig. 26, it is possible to project each lower plate part outwardly along the horizontal direction and bend a projecting edge of a part exposed outside downwardly. Shortly, the lower plate part can be bent in a different direction from that in the organic EL module 105 shown in Fig. 26.

Further, as shown in Fig. 27, the present invention may employ an organic EL module 201 in which leg parts 231 of a cathode-side connecting metal fitting 221 and leg parts 241 of an anode-side connecting metal fitting 223 do not necessarily project outwardly. Specifically, projecting ends of a lower plate part 235 of the leg part 231 of the cathode-side connecting metal fitting 221 and a lower plate part 245 of the leg part 241 of the anode-side connecting metal fitting 223 may be located within the opening 549 of the frame 504. In this case, a plate member 202 having an electrical conductivity and separately formed may be fixed to the respective lower plate part (the lower plate part 235, the lower plate part 245) via a fixing member such as a bolt, a screw, a nail, or a rivet or directly by means such as welding with the plate member 202 exposed outside. Specifically, a part where the respective lower plate part (the lower plate part 235, the lower plate part 245) and the plate member 202 are connected may be located within the frame 504 with a part of the plate member 202 exposed outside. Also in this case, similarly to the case of the organic EL module 501 in the above-mentioned second embodiment and the like, the organic EL modules 201 can be connected to each other.

Alternatively, in a case where a leg part 331 of a cathode-side connecting metal fitting 321 (see Fig. 28) and a leg part 341 of an anode-side connecting metal fitting 323 (see Fig. 28) are not exposed outside, adjacently disposed organic EL modules 301 may be connected to each other as mentioned below. Referring to Figs. 28 and 29, when the organic EL modules 301 are connected to each other, a plate member 302 having an electrical conductivity and separately formed may be sandwiched between the two organic EL modules 301 with the respective leg part (the leg part 331, the leg part 341) and the plate member 302 fixed via a fixing member such as a bolt while the two organic EL module 301 are adjacently disposed. At this time, though not particularly limited, as shown in Fig. 29, a distal end of the plate member 302 may be placed on a leg part 341a of an anode-side connecting metal fitting 323a of one organic EL module 301a, while a proximal end of the plate member 302 may be placed on a leg part 341b of an anode-side connecting metal fitting 323b of the other organic EL module 301b. Alternatively, they may be placed below the respective leg parts (the leg part 341a, the leg part 341b) (not shown). The fixing member such as a bolt may be driven through at least the frame 504, the leg part (the leg part 331, the leg part 341), and the plate member 302 from under (or above) the frame 504.

The module member employed in the present invention is not limited to one in the above-mentioned embodiments.

As shown in Fig. 30, for example, a frame 605 may serve as a module member for attaching the organic EL module to an outside. The frame 605 may be made up of a top face part 606, a bottom face part 607, and a vertical wall part 608 connecting the top face part 606 and the bottom face part 607 and have a holding space 610 defined by the top face part 606, the bottom face part 607, and the vertical wall part 608.

Herein, the top face part 606 has throughholes 611a and 611b at its one side (side extending in a width direction W). The throughholes 611a and 611b each have an opening of a square shape and are aligned in a row in the width direction W with a predetermined interval. Specifically, at least one of the throughholes 611a and 611b formed in the top face part 606 is located on a vertically projected surface of a throughhole (the anode-side connector insertion hole 58 in the first embodiment) reaching the second power supply member when the frame 605 is attached to the organic EL panel 2 and the electricity supply member 3. In this embodiment, the throughholes 611a and 611b are located on the vertically projected surfaces of the throughhole reaching the first power supply member and of the throughhole reaching the second power supply member, respectively.

Specifically, the anode-side connector insertion hole 58 and the cathode-side connector insertion hole 57 in the first embodiment may be appropriately modified in position (see Fig. 5 and the like) and may be formed at a part close to the edge of the electricity supply member 3.

Moreover, the top face part 606 may be modified in shape so that a part of the top face part 606 is located in a vertically projected region of the light-emitting region of the organic EL panel. Then, the throughholes 611a and 611b may be located in the vertically projected region of the light-emitting region of the organic EL panel.

Herein, the throughholes 611 a and 611b are holes penetrating the top face part 606 in its member thickness direction and being continuous to a holding space 610.

Meanwhile, two sides (sides extending in a longitudinal direction L) of the top face part 606 located at both ends of the one side having the throughholes 611a and 611b each have at least one protruding part 612. This embodiment has three protruding parts 612 at each side, so as to have six parts 612 in total at the both sides. The protruding parts 612 are aligned in a row in the longitudinal direction L with predetermined intervals.

Each of the protruding parts 612, as shown in Fig. 30, has a first shaft part 615, a second shaft part 616, and a third shaft part 617 from a distal end side (the top face part 606 side) to a proximal end side in the protruding direction. The first shaft part 615, the second shaft part 616, and the third shaft part 617 each have a columnar shape with a central axis positioned on the same straight line. Further, a side face of the first shaft part 615 and a side face of the second shaft part 616 are continuous in a step manner, while the side face of the second shaft part 616 and a side face of the third shaft part 617 are continuous in a step manner.

An outer diameter L1 of the first shaft part 615 is smaller than an outer diameter L2 of the second shaft part 616 and is the same as an outer diameter L3 of the third shaft part 617. The outer diameter L2 of the second shaft part 116 is smaller than a maximum diameter R3 of a large-diameter hole 663 of a fixing hole 661 of a base 650 (specifically mentioned below) shown in Fig. 32 and larger than a maximum diameter R1 of a small-diameter hole 662 of that. Further, the outer diameter L1 of the first shaft part 615 is slightly smaller than a width R2 of a constricted part (a boundary part between the large-diameter hole 663 and the small-diameter hole 662) of the fixing hole 661.

Now, the base 650 will be described in detail below.

The base 650 is a member to be used by being integrally attached to a wall or a ceiling. Engagement of the organic EL module housed in the frame 605 with the base 650 integrally attaches the organic EL module to a wall or a ceiling (the specific procedures of the engagement will be described below).

The base 650 is, as shown in Fig. 31, formed of a support member 654, a mounting part 651, and connector parts 652 and 653.

The support member 654 is formed of a main body 655, fixing parts 656 and 657, and connecting parts 658 and 660 connecting the main body 655 and the fixing parts 656 and 657. The main body 655 projects relative to the fixing parts 656 and 657. Specifically, the main body 655 is located at a position different from those of the fixing parts 656 and 657 in a member thickness direction (in a vertical direction in Fig. 31).

The main body 655 has a plurality of fixing holes 661 (661 a to 661f) as shown in Fig. 31. The fixing hole 661 has an opening of a shape of two circles having different diameters and partialy overlapping, as shown in Fig. 32. That is, the fixing hole 661 is a hook slot or key hole having a gourd-shaped opening. Specifically, the fixing hole 661 consists of the large-diameter hole 663 and the small-diameter hole 662. The fixing holes 661 each face the same direction with the large-diameter hole 663 located nearer the mounting part 651 (the connector parts 652 and 653 side) than the small-diameter hole 662.

The fixing holes 661 (661a, 661c, 661e and 661b, 661d, 661f) are arranged in a row in the vicinity of respective sides extending in the longitudinal direction L.

Herein, other than the above-mentioned embodiment, the connecting part 658 may have a slit-shaped insertion hole extending in the width direction W for attaching several kinds of members.

As shown in Figs. 33A and B, the base 650 is additionally provided with the mounting part 651 on which known mounting components such as a DC stabilization power source and components for light control, toning, signal transmission, and the like are mounted. The mounting part 651 is electrically connected to the connector parts 652 and 653.

Herein, the connector parts 652 and 653 are members to electrically connect the exposed parts of the first power supply member and the second power supply member to the mounting part 151 when the organic EL panel is attached.

Herein, the first power supply member and the second power supply member serves as the cathode-side connecting metal fitting 21 and the anode-side connecting metal fitting 23 in the above-mentioned first embodiment. Specifically, it can be said that the connector parts 652 and 653 are used instead of the elastic connectors 50 in the first embodiment.

Next, a positional relationship between the members will be described in detail below according to general procedures when the organic EL module 601 (see Figs. 33A and B) is attached to a ceiling or the like via the base 650.

First, an electricity supply member and the organic EL panel 2 are housed in the frame 605, so as to make up the organic EL module 601. Specifically, the electricity supply member including at least a first power supply member and a second power supply member and the organic EL panel 2 are housed in the frame 605 and are electrically connected to each other. More specifically, the frame 605 is expanded or stretched so as to become larger than the external dimension of the electricity supply member and the organic EL panel 2 utilizing elasticity and flexibility of the frame 605. Then, the edge parts of the electricity supply member and the organic EL panel 2 are fitted into the holding space 110 of the frame 605.

At this time, the openings of the throughholes 611a and 611 b are respectively positioned above the exposed parts of the first power supply member and the second power supply member of the electricity supply member.

Herein, in the organic EL module 601, since the frame 605 having elasticity and flexibility is expanded so as to make the organic EL panel 2 and the electricity supply member fit thereinto, a recovery force of the frame 605 presses those members. This prevents the frame 605 from being detached from the organic EL panel 2 and the electricity supply member.

Next, a positional relationship of the members will be described in detail below according to general procedures when the organic EL module 601 having been made up by the above-mentioned procedures is attached to the base 150.

As shown in Figs. 33A and B, after each of the protruding parts 612 is inserted until the first shaft part 615 (see Fig. 30) resides within the fixing hole 661, the organic EL module 601 is slid along the longitudinal direction L.

At this time, the first shaft part 615 moves into the small-diameter hole 662 beyond the constricted part (the boundary part of the large-diameter hole 663 and the small-diameter hole 662) of the fixing hole 661. Meanwhile, the second shaft part 616 is locked by the small-diameter hole 662, so that the organic EL module 601 is prevented from removing from the base 650 in a vertical direction. Further, the first shaft part 615 is engaged in the small-diameter hole 662.

Now, an organic EL module 700 in still another embodiment will be described below.

The organic EL module 700, as shown in Fig. 34, has a frame 701 (module member) for covering four sides.

The frame 701 has an opening 703 on its rear side, as shown in Figs. 33 and 34.

The organic EL panel 2 and an electricity supply member 710 are housed in the frame 701 as shown in Figs. 33 and 34. Herein, the electricity supply member 710 includes at least a first power supply member and a second power supply member (shown as if being a plate-like shape for convenience for showing them in figure). The first power supply member and the second power supply member have substantially the same outer shapes as those of the cathode-side connecting metal fitting 21 and the anode-side connecting metal fitting 23 described above, respectively. The cathode-side connector insertion hole 57 and the anode-side connector insertion hole 58 are appropriately changed in position.

The electricity supply member 710, as shown in Figs. 33 and 34, has plane contact with only the rear face of the organic EL panel 2.

In this embodiment, an iron plate 713 (module member) is attached to the rear face side of the organic EL panel 2 and further the rear face side of the electricity supply member 710 (at a lower side in Figs. 33 and 34).

Further, in this embodiment, the first power supply member and the second power supply member can be seen through the opening 703. Specifically, a throughhole reaching the first power supply member of the electricity supply member 710 and a throughhole reaching the second power supply member thereof (the cathode-side connector insertion hole 57 and the anode-side connector insertion hole 58 in the first embodiment) overlap with the opening 703 in position. In other words, the throughhole reaching the first power supply member and the throughhole reaching the second power supply member are arranged in a vertically projected region of the opening 703.

The organic EL module 700 in this embodiment is attached to a base 711 as shown in Fig. 32.

The base 711 has a concave portion 712 in which the organic EL module 700 is completely accommodated and in which a mounting part 715 is provided. The mounting part 715 may incorporate a circuit board including a rectifier circuit.

Further, the mounting part 715 is provided with contact pins 716. The contact pins 716 each are a conductive body having elasticity itself

The base 711 has a magnet 720 secured thereto.

In this embodiment, the organic EL module 700 is attached to the base 711 with magnetic force. In this state, the contact pins 716 are inserted in the opening 703 of the frame 701, so as to be in contact with the first power supply member and the second power supply member.

Specifically, the organic EL module 700 is attached and electrically conducted to the base 711 with the magnet 720. The organic EL module 700 and the base 711, which are thus integrated with each other, are preferably attached to a surface to be placed such as a wall with the magnetic force of the magnet 720.

In short, in this embodiment, the frame 701 and the iron plate 713 serve as the module members.

In the process of securing with the magnetic force, the contact pins 716 (spring probes, for example) contract via the opening 703 (notch, for example) of the frame 701 (frame, for example), thereby, for example, bringing the first power supply member and the second power supply member, each of which is a copper foil electrically connected to the electrode layer, in electrical contact with a circuit board provided in the base 711 with high reliability, so that power can be supplied from outside.

The contact pins 716 may be disposed on a side of the first power supply member or the second power supply member. It is also a preferred embodiment to attach a stretchable contact member (coil connector made by Yokowo Co., Ltd., for example) to the members so as to be accommodated in the opening 703. The coil connector contracts with magnetic force, thereby allowing electrical conduct with the circuit board.

Also in this embodiment, the frame 701 presses the first power supply member and the second power supply member onto the electrode parts 10 (see Fig. 2 and the like) of the organic EL panel 2.

As described above, the module member employed in the present invention may be a frame-like body covering at least one side of the substrate or at least a part of one side of the substrate and also a planar body covering at least one side of the substrate or at least a part of one side of the substrate.

### DESCRIPTION OF NUMERALS

1, 105, 201, 301, 501, 601, 700. organic EL module
2, 502. organic EL panel (organic EL device)
11. first electrode part (first conductive region)
12. second electrode part (second conductive region)
21, 221, 321, 521. cathode-side connecting metal fitting (first power supply member, first power supply member)
22, 522. insulation plate (insulation layer)
23, 223, 323, 523. anode-side connecting metal fitting (second power supply member, second power supply member)
24, 524. top plate forming member (planar body, module member)
30, 40. main body
31,41. leg part
33,43. leg part
34, 44. vertical wall part
36, 536. cathode-side void part (first power supply member void part)
42. connector connecting hole (throughhole)
46, 546. anode-side void part (second power supply member void part)
50. elastic connector (electric wire)
57. cathode-side connector insertion hole (connector insertion hole)
58. anode-side connector insertion hole (connector insertion hole)
61. cathode-side hole for mounting work (position adjustment hole)
62. anode-side hole for mounting work (position adjustment hole)
202, 302. plate member (first conducting member, second conducting member)
605. frame (module member)
713. iron plate (module member)

## Claims

1. An organic EL module incorporating an organic EL device having a layer structure formed of at least a first electrode layer, an organic light-emitting layer, and a second electrode layer and stacked on a substrate having a planar expanse, wherein the substrate has sides or a peripheral part, the organic EL module comprising:
a first power supply member;
an insulation layer;
a second power supply member; and
at least two electric wires,
the first power supply member and the second power supply member each having a plate or foil shape and having an outer edge part and an edge end,
the first power supply member and the second power supply member having a first power supply member void part and a second power supply member void part formed by cutting out a part of the members, respectively,
the first power supply member and the second power supply member being different in shape from each other,
at least a part of the first power supply member being located in a region where the second power supply member void part is vertically projected and at least a part of the second power supply member being located in a region where the first power supply member void part is vertically projected when the first power supply member and the second power supply member overlap,
the first power supply member and the second power supply member overlapping each other with the insulation layer sandwiched therebetween,
one of the electric wires penetrating the second power supply member being connected to the first power supply member,
the first power supply member, to which the one of the electric wires is connected, being connected to one selected from a group consisting of the first electrode layer and the second electrode layer either directly or via a conducting member, and
the second power supply member, to which the other of the electric wires is connected, being connected to the other selected from the group consisting of the first electrode layer and the second electrode layer either directly or via a conducting member.

2. The organic EL module as defined in claim 1,
the first power supply member void part being formed at the outer edge part of the first power supply member, and
at least a part of the second power supply member being located outward of the edge end of the first power supply member.

3. The organic EL module as defined in claim 1 or 2,
the second power supply member void part being formed at the outer edge part of the second power supply member, and
at least a part of the first power supply member is located outward of the edge end of the second power supply member.

4. The organic EL module as defined in one of claims 1 to 3,
having a first conductive region formed adjacent to the side of the substrate,
wherein the first conductive region is conducted with one selected from a group consisting of the first power supply member and the second power supply member,
having a second conductive region formed adjacent to the side of the substrate and at a position different from the first conductive region,
wherein the second conductive region is conducted with the other selected from the group consisting of the first power supply member and the second power supply member,
a part located at the outer edge part of the second power supply member and outward of the edge end of the first power supply member being in contact with one selected from a group consisting of the first conductive region and the second conductive region, and
a part located at the outer edge part of the first power supply member and outward of the edge end of the second power supply member being in contact with the other selected from the group consisting of the first conductive region and the second conductive region.

5. The organic EL module as defined in one of claims 1 to 4,
the first power supply member and the second power supply member being formed by punching a metal foil or a metal plate.

6. The organic EL module as defined in one of claims 1 to 5,
the first power supply member and the second power supply member each having a main body and a leg part,
the main body having a flat plate shape and an outer edge constituted by sides, and
the leg part being formed integrally with the side of the main body.

7. The organic EL module as defined in claim 6,
the leg part having a projecting piece part projecting from the outer edge of the main body to a direction containing components of a horizontal direction and a vertical wall part projecting downwardly from the projecting piece part, and
the leg part of the first power supply member being separated from the second power supply member and the leg part of the second power supply member being separated from the first power supply member.

8. The organic EL module as defined in one of claims 1 to 7,
the second power supply member having a throughhole for inserting one of the electric wires therethrough.

9. The organic EL module as defined in one of claims 1 to 8,
further comprising a module member covering either at least one side of the substrate or at least a part of a surface of the substrate,
the module member being a frame or a planar body, and
the module member pressing and fixing the first power supply member and the second power supply member.

10. The organic EL module as defined in claim 9,
the module member having a module throughhole penetrating a part of the member in a member thickness direction,
the module throughhole being at least a part of a communicating hole extending from outside to the first power supply member and/or at least a part of a communicating hole extending from outside to the second power supply member.

11. The organic EL module as defined in one of claims 1 to 10,
having a connector insertion hole for inserting one of the electric wires therethrough,
wherein the connector insertion hole extends through the second power supply member, and
having adjacent to the connector insertion hole a position adjustment hole for adjusting a position of the electric wires,
wherein the position adjustment hole extends through at least the second power supply member.

12. The organic EL module as defined in claim 9,
having the module member formed by a ferromagnetic planar body of a plate or foil shape.

13. The organic EL module as defined in one of claims 1 to 12,
the first power supply member being conducted with one selected from a group consisting of the first electrode layer and the second electrode layer,
the second power supply member being conducted with the other selected from the group consisting of the first electrode layer and the second electrode layer,
the first power supply member and the second power supply member forming connecting parts in pairs,
the connecting parts being formed at either a plurality of sides of the substrate or a plurality of parts of the peripheral part of the substrate,
so that a conductive body other than the components of the organic EL module has direct contact with the respective connecting parts from a side face of the organic EL module.

14. The organic EL module as defined in claim 13,
the substrate being polygonal or circular in shape, and
at least a part of the connecting parts being arranged on at least two opposing sides of the substrate.

15. The organic EL module as defined in claim 13 or 14,
the connecting parts projecting outwardly from the sides or the peripheral part of the substrate.

16. An organic EL module incorporating an organic EL device having a layer structure formed of at least a first electrode layer, an organic light-emitting layer, and a second electrode layer and stacked on a substrate having a planar expanse, wherein the substrate has sides or a peripheral part, comprising connecting parts each constituted by a pair of conducting members,
wherein the conducting members mainly consist of a first conducting member conducted to the first electrode layer and a second conducting member conducted to the second electrode layer,
the connecting parts being formed at either a plurality of sides or a plurality of parts of the peripheral part of the substrate,
so that a conductive body other than components of the organic EL module has direct contact with the respective connecting part from a side face side of the organic EL module.

17. The organic EL module as defined in claim 16,
the substrate being polygonal or circular in shape, and
at least a part of the connecting parts being arranged on at least two opposing sides of the substrate.

18. The organic EL modules as defined claim 16 or 17,
the connecting parts projecting outwardly from the sides or the peripheral part of the substrate.

19. The organic EL module as defined in one of claims 16 to 18, comprising;
a first power supply member;
an insulation layer; and
a second power supply member,
the first power supply member and the second power supply member each having a plate or foil shape,
the first power supply member and the second power supply member having a first power supply member void part and a second power supply member void part formed by cutting out a part of the members, respectively,
the first power supply member and the second power supply member being different in shape from each other,
at least a part of the first power supply member being located in a region where the second power supply member void part is vertically projected and at least a part of the second power supply member being located in a region where the first power supply member void part is vertically projected when the first power supply member and the second power supply member overlap,
the first power supply member and the second power supply member overlapping each other with the insulation layer sandwiched therebetween,
the first power supply member being connected to one selected from a group consisting of the first electrode layer and the second electrode layer either directly or via a conducting member,
the second power supply member being connected to the other selected from the group consisting of the first electrode layer and the second electrode layer either directly or via a conducting member, and
the first power supply member and the second power supply member respectively serving as the first conducting member and the second conducting member, so as to constitute the connecting part in pairs.

20. The organic EL module as defined in one of claims 1 to 19 being easily attachable to another member with a magnetic power.

21. A power supply structure made up of organic EL modules,
wherein the organic EL modules as defined in one of claims 13 to 20 are placed without gaps with a planar expanse,
the connecting parts belonging to adjacent organic EL modules that are connected to each other, and
at least one of the organic EL modules being electrically connected to an external electrode.

22. The power supply structure as defined in claim 21,
the connecting parts being connected to each other above the substrate.

23. The power supply structure as defined in claim 21,
the connecting parts being connected to each other at outside of the substrate.

24. A power supply structure made up of the organic EL modules as defined in one of claims 13 to 20,
being made by connecting a plurality of parallelly-connected module rows in series,
each of the parallelly-connected module rows being made up of the organic EL modules adjacently located and electrically connected to each other in parallel.
